# EUROPEAN PATENT APPLICATION

(11) **EP 1 975 719 A2**
(43) Date of publication of application: **01.10.2008**
(21) Application number: 08005983.5
(22) Date of filing: 28.03.2008
(51) Int. Cl.: G03F 7/11, G03F 7/20, G03F 7/09, G03F 7/16

(54) **Method of forming resist pattern and semiconductor device manufactured with the same**

(30) Priority: 30.03.2007 JP 2007094042; 31.01.2008 JP 2008021604
(71) Applicant: Renesas Technology Corp., Tokyo 100-0004 (JP)
(72) Inventor: Ishibashi, Takeo, Tokyo 100-0004 (JP); Terai, Mamoru, Tokyo 100-8310 (JP); Hagiwara, Takuya, Tokyo 100-0004 (JP); Yamaguchi, Atsumi, Tokyo 100-0004 (JP)
(74) Representative: Klein, Peter

(57) **Abstract**

A method of forming a resist pattern through liquid immersion exposure in which exposure is performed such that a liquid film is formed between a substrate for a semiconductor device on which a processed film is formed and an objective lens arranged above the substrate is provided, and the substrate treated with a water-repellent agent solution composed of at least a water-repellent agent and a solvent is exposed to light.

## Description

### BACKGROUND OF THE INVENTION

### Field of the Invention

The present invention relates to a method of forming a resist pattern with high water-repellency required in liquid immersion exposure and high film-peeling suppression effect, and a semiconductor device manufactured with that method.

### Description of the Background Art

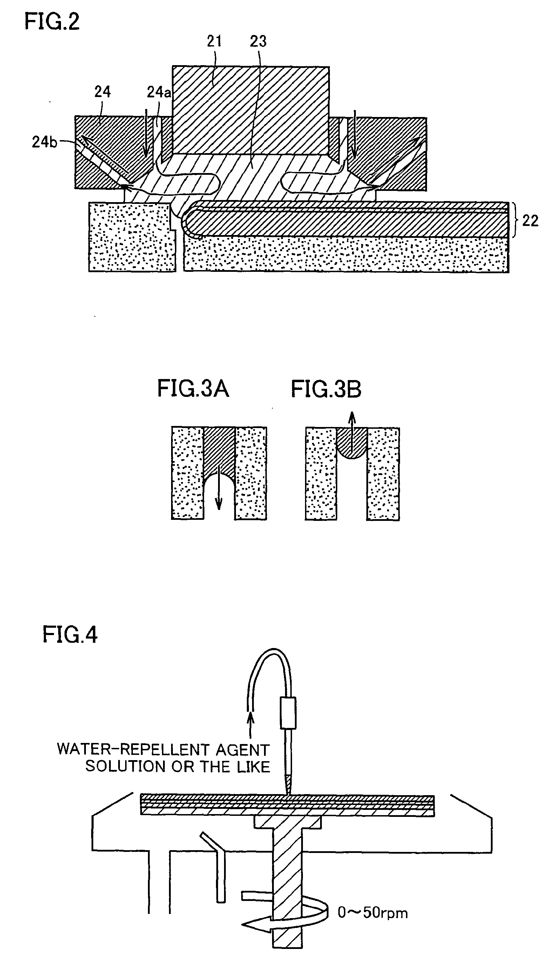

In forming a resist pattern with liquid immersion type exposure, an apparatus structured as shown in Fig. 2 is used (see Tomoharu Fujiwara et al., "Wafer Management between Coat/Developer Track and Immersion Lithography Tool," Optical Microlithography XIX edited by Donis G. Flagello, Proc. of SPIE, vol. 6154, 2006). In the liquid immersion type exposure apparatus, a wafer 22 is arranged under a lens 21 and purified water 23 is introduced from an inlet port 24a of a nozzle 24 and ejected from a suction port 24b such that a space between lens 21 and an irradiated surface of wafer 22 is filled with purified water 23. On the irradiated surface, a resist film for photolithographic patterning is formed as a single-layer resist film or a multi-layer resist film. In a case of the latter, that is, the multi-layer resist film, a structure of the resist film for photolithographic patterning is complicated, and at least three types of layers of a lower organic film layer, a silicon-containing intermediate layer, and a photosensitive resist layer implement the resist film for photolithographic patterning. In addition, in liquid immersion type exposure (liquid immersion lithography), in order to avoid organic contamination by a liquid for liquid immersion due to direct contact between the liquid for liquid immersion and the photosensitive resist layer, a top coat layer may be formed on the photosensitive resist layer serving as the uppermost layer of the resist film for photolithographic patterning.

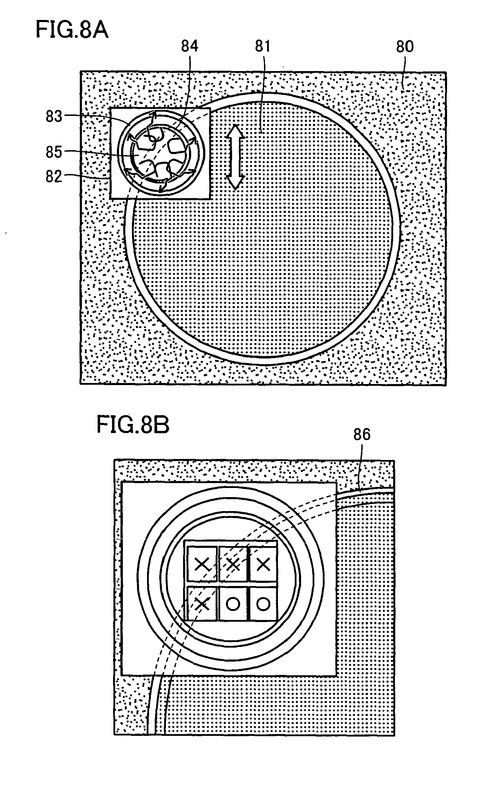

In liquid immersion type exposure, a film of water (meniscus) is formed in a small gap between the lens and the wafer by utilizing surface tension of water, so that a high index of refraction is achieved between the lens and the wafer which is the irradiated surface. In exposing a wafer peripheral portion to light using the liquid immersion apparatus of a meniscus-forming-type, such a defective shot that a part of the meniscus extends off the wafer. Fig. 8A shows a plan view of the liquid immersion type exposure apparatus. A liquid immersion shower head 82 scans a wafer 81 placed on a stage 80 in a direction shown with an arrow. Shower head 82 is charged with a lens 85, and purified water is introduced from a water inlet port 84 and ejected from a water suction port 83. Fig. 8B is an enlarged view of a portion of liquid immersion shower head 82 when a peripheral portion of wafer 81 is exposed to light. Two chips marked with a circle can be used as operating chips, however, four chips marked with a cross are discarded, because the meniscus extends off the wafer. In thus exposing the wafer peripheral portion to light, such a defective shot that a part of the meniscus extends off the wafer is produced.

In a case of the defective shot as shown in Fig. 8B, a part of water filling a gap between wafer 81 and lens 85 may spill through a gap 86 between wafer 81 and an outer frame of stage 80. If a large amount of the liquid for liquid immersion spills, the meniscus collapses and liquid immersion exposure itself becomes impossible. In addition, even if an amount of spill is small, the exposure apparatus or a back surface of a substrate is contaminated, which leads to secondary damage causing defocusing due to foreign matters on the back surface of the substrate, in a wafer that is subsequently exposed to light. Moreover, in liquid immersion exposure of a defective shot, if adhesion of a coating film at a wafer edge to the substrate is weak, the film peels off. Then, foreign matters that have peeled off from the edge are introduced in the liquid for liquid immersion having flow velocity, the liquid for liquid immersion of wafers is contaminated, and a pattern defect is caused in a center portion of the wafer.

Fig. 3 shows behavior of water in a capillary. Fig. 3A shows an example where an inner surface of the capillary is hydrophilic and water moves forward within the capillary in a direction shown with an arrow as a result of capillarity. On the other hand, Fig. 3B shows an example where the inner surface of the capillary is water-repellent and water moves backward as a result of capillarity. Accordingly, conventionally, spill of the liquid for liquid immersion has been suppressed utilizing capillarity, by designing an apparatus such that a gap between a wafer and an outer frame of a stage is minimized, employing a water-repellent member for the outer frame of the stage, and coating the entire wafer surface including also a wafer outer peripheral portion with a water-repellent coating film.

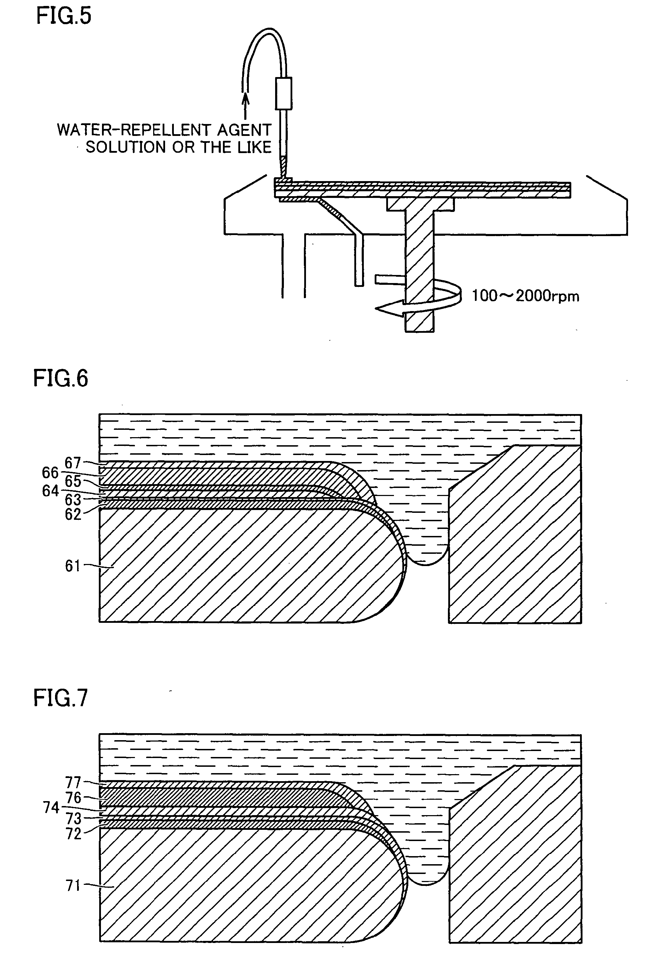

Thus, in order to lift a liquid upward by utilizing capillarity, a surface of a capillary that comes in contact with water should be water-repellent and an angle of contact should be great. Fig. 6 illustrates a conventional multi-layer resist film that has been made water-repellent. As shown in Fig. 6, a substrate 61 is made water-repellent by subjecting a film to be processed (hereinafter referred to as processed film) 62 itself formed on substrate 61 to silylation in vapor-phase using hexamethyldisilazane (hereinafter also referred to as "HMDS"), to form an HMDS-treated region 63, and a side surface portion (beveled portion) and a peripheral portion of a top surface of the wafer are made water-repellent with HMDS. Thereafter, a lower organic film layer 64, a silicon-containing intermediate layer 65, and a photosensitive resist layer 66 are formed. Then, a top coat layer 67 water-repellent and soluble in a developer and serving as a protection film in liquid immersion is formed. Here, top coat layer 67 water-repellent and soluble in a developer is exposed at an outermost surface also in the vicinity of a wafer outer periphery, to thereby enhance capillarity. Fig. 7 illustrates a conventional single-layer resist film that has been made water-repellent. As shown in Fig. 7, a substrate 71 is made water-repellent by forming an HMDS-treated region 73 on a processed film 72 formed on substrate 71. Thereafter, a coating-type organic anti-reflection film 74 and a photosensitive resist layer 76 are formed, and a top coat layer 77 water-repellent and soluble in a developer and serving as a protection film in liquid immersion is formed.

With such a conventional method, however, water repellency of a beveled portion remains at a level attained by the HMDS treatment and an angle of contact against water is approximately 60°. Therefore, water-repellency may be insufficient. In addition, as treatment with HMDS can be directed only to treatment of the processed film before formation of various types of coating films, and the treatment is premised on treatment of the entire surface of the wafer. Therefore, water-repellency to such an extent as not affecting pattern formation could only be provided. In addition, in order to maintain water-repellency at the wafer outer peripheral portion, removal at edge (hereinafter referred to as edge removal) of a resist or the like around the wafer outer periphery is restricted, and measures against dust production are limited. Moreover, it is only adhesion between the processed film and a coating film directly on the same that can be improved in order to suppress peeling, and such an improvement is not sufficient as an effect to suppress a pattern defect caused by film peeling. Foreign matters produced by peeling from a wafer edge float due to convection of the liquid for liquid immersion during liquid immersion exposure and a pattern defect may be induced. Further, in the conventional water-repellent treatment, water-repellent treatment of the entire surface of the wafer may adversely affect a step of exposure to light, and a method of providing preferred water-repellency to the entire surface has not been studied.

### SUMMARY OF THE INVENTION

An object of the present invention is to provide a method of forming a resist pattern with sufficiently high water-repellency required in liquid immersion exposure and high film-peeling suppression effect, and a semiconductor device manufactured with that method.

According to one embodiment of the present invention, a method of forming a resist pattern through liquid immersion exposure in which exposure is performed such that a liquid film is formed between a substrate for a semiconductor device on which a processed film is formed and an objective lens arranged above the substrate is provided, and the substrate treated with a water-repellent agent solution composed of at least a water-repellent agent and a solvent is exposed to light. In addition, according to another embodiment of the present invention, a semiconductor device manufactured with such a method of forming a resist pattern is provided.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Figs. 1A and 1B illustrate typical examples of water-repellent treatment according to the present invention, where a top coat layer covers an outermost surface, Fig. 1A showing a process flow and Fig. 1B being a schematic diagram showing a cross-sectional structure of a wafer outer peripheral portion after the treatment.
Fig. 2 illustrates a structure of an apparatus for forming a resist pattern through liquid immersion type exposure.
Figs. 3A and 3B illustrate behavior of water in a capillary, Fig. 3A being a schematic diagram showing behavior of water when all inner surface of a capillary is hydrophilic and Fig. 3B being a schematic diagram showing behavior of water when an inner surface of a capillary is water-repellent.
Fig. 4 illustrates an example of an apparatus for water-repellent treatment by forming a liquid film of a water-repellent agent solution or the like.
Fig. 5 illustrates another example of an apparatus for water-repellent treatment by forming a liquid film of a water-repellent agent solution or the like.
Fig. 6 illustrates a structure of a conventional multi-layer resist film subjected to water-repellent treatment.
Fig. 7 illustrates a structure of a conventional single-layer resist film subjected to water-repellent treatment.
Figs. 8A and 8B are plan views of a liquid immersion type exposure apparatus, Fig. 8A being a plan view showing the liquid immersion type exposure apparatus and Fig. 8B being an enlarged schematic diagram of a part of a liquid immersion shower head 82 when a peripheral portion of a wafer 81 is exposed to light.
Figs. 9A to 9C illustrate typical examples of water-repellent treatment according to the present invention, where a top coat layer is not formed, Fig. 9A showing a process flow and Figs. 9B and 9C being schematic diagrams showing exemplary cross-sectional structures of wafer outer peripheral portions after the water-repellent treatment, respectively.
Figs. 10A and 10B illustrate typical examples of water-repellent treatment according to the present invention, where a top coat layer is formed and edge rinse and water-repellent treatment are simultaneously performed, Fig. 10A showing a process flow and Fig. 10B being a schematic diagram showing an exemplary cross-sectional structure of a wafer outer peripheral portion after the water-repellent treatment.
Figs. 11A and 11B illustrate typical examples of water-repellent treatment according to the present invention, where a top coat layer is not formed and edge rinse and water-repellent treatment are simultaneously performed, Fig. 11A showing a process flow and Fig. 11B being a schematic diagram showing an exemplary cross-sectional structure of a wafer outer peripheral portion after the water-repellent treatment.
Figs. 12A and 12B illustrate typical examples of water-repellent treatment according to the present invention, where a top coat layer is not formed, edge rinse of a photosensitive resist layer is performed and adhesion between a silicon-containing intermediate layer and the photosensitive resist layer is enhanced, Fig. 12A showing a process flow and Fig. 12B being a schematic diagram showing an exemplary cross-sectional structure of a wafer outer peripheral portion after the water-repellent treatment.
Figs. 13A to 13C illustrate typical examples of water-repellent treatment according to the present invention, where adhesion between a photosensitive resist and a top coat layer is enhanced, Fig. 13A showing a process flow and Figs. 13B and 13C being schematic diagrams showing exemplary cross-sectional structures of wafer outer peripheral portions after the water-repellent treatment, respectively.
Fig. 14 illustrates variation in an angle of contact and adhesion strength with increase in an amount of an epoxy silane coupling agent.
Figs. 15A to 15F illustrate a patterning step after a photosensitive resist layer is formed in an example where a top coat layer does not cover an outermost surface of a wafer, Figs. 15A to 15F being schematic diagrams showing respective steps in patterning.
Figs. 16A to 16H illustrate a patterning step after a photosensitive resist layer is formed in an example where a top coat layer soluble in a developer covers an outermost surface of a wafer and a water-repellent and adhesion-strengthening layer is formed only at a wafer outer peripheral portion, Figs. 16A to 16H being schematic diagrams showing respective steps in patterning.
Figs. 17A to 17C are schematic diagrams showing resist patterns, Fig. 17A being a schematic diagram showing an exemplary pattern, Fig. 17B being a schematic diagram showing pattern toppling, and Fig. 17C being a schematic diagram showing a normal pattern.

### DESCRIPTION OF THE PREFERRED EMBODIMENTS

A method of forming a resist pattern according to the present invention is characterized in that, in a method of forming a resist pattern through liquid immersion exposure, a substrate treated with a water-repellent agent solution composed of at least a water-repellent agent and a solvent is exposed to light. By treating a wafer with the water-repellent agent solution in a liquid state, strong water-repellency can be achieved. Therefore, an effect to suppress spill of a liquid for liquid immersion utilizing strong capillarity can be enhanced. In the conventional HMDS treatment, an angle of contact against water remains around 60°, and water-repellency to such an extent as not affecting pattern formation could only be obtained. According to the present invention, however, water-repellent treatment strong enough to achieve an angle of contact against water of approximately 80°or greater is possible. Therefore, according to the method of forming a resist pattern of the present invention, collapse of meniscus and contamination of a back surface of the substrate is prevented, and a high-quality semiconductor device free from a pattern defect due to defocusing caused by foreign matters on the back surface of the wafer can be provided. In liquid immersion lithography, in order to avoid organic contamination by a liquid for liquid immersion, a top coat layer soluble in a developer may be formed on a photosensitive resist layer. The top coat layer soluble in a developer is generally water-repellent. Therefore, when the top coat layer covers an outermost surface, such a structure is relatively advantageous to liquid spill during liquid immersion exposure at a wafer peripheral portion. On the other hand, when the top coat layer soluble in a developer is not used in view of cost or the like, the water-repellent treatment method according to the present invention is particularly effective.

If water-repellent treatment affects resist coating performance and adversely affects pattern formation, only the outer peripheral portion of the wafer, where a defective shot is produced and from which a semiconductor chip cannot be obtained, should selectively be made water-repellent. According to the method of the present invention, as an agent used for water-repellent treatment is in a liquid state, only the outer peripheral portion of the wafer can selectively be subjected to water-repellent treatment, for example, by spraying a water-repellent treatment agent only to the outer peripheral portion of the wafer. In addition, as such a treatment is directed to the outer peripheral portion of the wafer that does not affect patterning, water-repellent treatment strong enough to achieve an angle of contact against water of approximately 80° or greater can be performed. In many cases, the outer peripheral portion of the wafer is subjected to edge removal as measures against dust production. In a multi-layer resist process, various edge removal forms may be required depending on a process. According to the conventional method, when edge removal is arbitrarily performed, a hydrophilic surface may be exposed at the outermost surface and therefore a degree of freedom in edge removal has been low. According to the present invention, however, the water-repellent treatment agent is selectively sprayed to and brought in contact with only the outer peripheral portion of the wafer from which a semiconductor product cannot be manufactured, so that the outermost surface can be made water-repellent with respect to every edge removal form.

If the lower organic film layer, the silicon-containing intermediate layer, and the photosensitive resist layer are to be formed on the substrate, these layers are preferably formed with the multi-layer resist method including the step of spin-coating the substrate with these layers, and treatment with a water-repellent agent solution is preferably performed at any timing of at least: in all invervals between the steps of spin-coating; before first spin-coating; and after last spin-coating. According to such treatment, unlike the conventional example where adhesion only between the processed film and the lower organic film layer directly thereon is improved, adhesion between the films in a multi-layer resist structure can be improved. In addition, peeling can be suppressed by selectively subjecting only the wafer outer peripheral portion where peeling is likely during liquid immersion exposure and adhesion is required to treatment with the water-repellent agent solution such as a silane coupling agent, without affecting a pattern formation region. An effect to strengthen adhesion can be obtained by employing the silane coupling agent as the water-repellent agent. Similarly, a photolithography step including the step of spin-coating the substrate with the photosensitive resist layer is further preferred, in terms of higher adhesion between the substrate and the photosensitive resist layer formed on the substrate, higher adhesion between the photosensitive resist layer and the top coat layer formed on the photosensitive resist layer, and suppression of peeling during liquid immersion exposure. In the photolithography step, treatment with the water-repellent agent solution containing a silane coupling agent or the like is preferably performed at any timing of at least: in all intervals between the steps of spin-coating; before first spin-coating; and after last spin-coating.

The processed film to be formed under the resist film for photolithographic patterning for forming the resist pattern is not particularly limited, and normally, the processed film is implemented by an inorganic film such as polysilicon, a silicon oxide film, a silicon nitride film, and an amorphous carbon film formed with CVD, or a film having a lower inorganic anti-reflection film formed thereon. The water-repellent treatment is performed on the outermost surface that comes in contact with water during liquid immersion exposure, out of the surface of the processed film serving as an underlying layer of the resist film for photolithographic patterning, and the film formed by stacking the lower organic film layer, the silicon-containing intermediate layer and the photosensitive resist layer formed on the substrate. In addition, the water-repellent treatment is not a treatment in vapor-phase but it is a treatment for providing water-repellency to a treated surface by spraying a liquid or by immersion in a liquid, the liquid being a water-repellent agent solution. Moreover, treatment by using a solution containing a silane coupling agent as the water-repellent agent solution (adhesion-strengthening treatment) that can be performed in a similar manner to water-repellent treatment can provide adhesion.

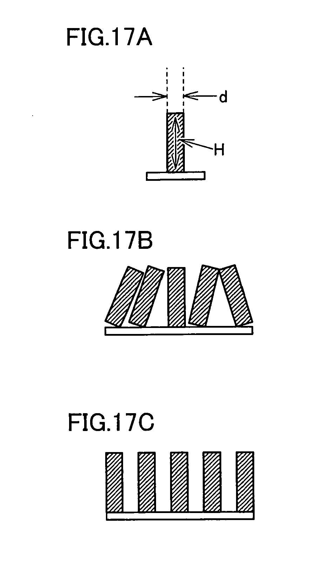

The entire surface of the wafer may also be made water-repellent, for example, by forming a liquid film by paddling a treatment solution composed of a water-repellent agent solution containing at least one water-repellent agent, with the use of an apparatus shown in Fig. 4. Here, though the number of revolutions of the wafer is basically set to rest (0 rpm), the wafer may be turned at 50rpm to shake at intervals of several seconds so as to stir the liquid. If the entire surface of the wafer is treated, however, a portion to be patterned of the resist film for photolithographic patterning, that should be applied in a subsequent step, is made water-repellent. Accordingly, the water-repellent treatment method is restricted because of concerns about detrimental effect on coating performance, development performance, and multi-layer process dry development performance. Therefore, it is likely that water-repellency to be aimed may be insufficient. In such a case, a non-fluorine-type water-repellent agent containing at least any of alkyl group and epoxy group in its structure is preferably used as the water-repellent agent which will be described later. Alternatively, sufficient water-repellency can be provided by adding to the water-repellent agent solution, at least any of water, acid and alkali. If the entire wafer surface is made water-repellent, an effect to suppress pattern toppling of the resist can further be improved. Figs. 17A to 17C show schematic diagrams of resist patterns. Fig. 17A shows an exemplary pattern having a film thickness (resist pattern height) H and a line width d, Fig. 17B is a schematic diagram showing pattern toppling, and Fig. 17C is a schematic diagram showing a normal pattern. As the resist pattern is made smaller regardless of liquid immersion exposure, an aspect ratio, i.e., film thickness H/line width d, becomes higher and an area of contact between the substrate and the resist pattern is decreased. Then, pattern toppling of the resist is more likely. According to the present invention, it was found that, if the entire surface of the wafer is treated with the water-repellent agent solution containing the water-repellent agent as described above, adhesion between the substrate and the resist can be improved and consequently pattern toppling can be suppressed. Therefore, if the water-repellent treatment of the entire surface of the wafer is restricted, the wafer outer peripheral portion can locally be treated as will be described later, however, in order to suppress the problem of pattern toppling or the like, the entire surface of the wafer is desirably made water-repellent.

If water-repellent treatment of the entire surface of the wafer is restricted, a method of locally performing water-repellent treatment or the like is available, with a water-repellent treatment area being limited to a side surface and a peripheral portion of a top surface and a peripheral portion of a bottom surface of the wafer except for the portion to be patterned (hereinafter collectively also referred to as "outer peripheral portion"). As shown in Fig. 5, this method is a method of locally treating the wafer outer peripheral portion with the water-repellent agent solution or the like by using an edge rinse mechanism. Specifically, while turning the wafer at approximately 100rpm to 2000rpm, only the peripheral portion of the top surface of the wafer is selectively treated with the water-repellent agent solution or the like so that the angle of contact against the liquid for liquid immersion is greater. Here, a width of a region to be subjected to water-repellent treatment in the peripheral portion can be adjusted to approximately 0.3mm to 3.0mm from the wafer edge, by controlling a nozzle position with high accuracy by means of a step motor. An edge rinse nozzle for removing a coating film on a wafer edge according to an existing technique may be used as it is as that nozzle, or if a nozzle other than a nozzle for edge rinse is to be used separately, an additional edge rinse nozzle is simply provided. It is noted that the coating film refers to a film that is temporarily formed on the substrate in order to obtain a desired pattern but does not finally remain as a film in a semiconductor device, such as a lower organic film, a silicon-containing intermediate layer, a resist and an anti-reflection film, and a top coat. In addition, the processed film encompasses the coating film described above as well as a member that finally remains as a film forming a semiconductor device among films including a substrate portion (silicon substrate, oxide film, nitride film, Low-K film, and the like) underlying the lower organic film.

The peripheral portion of the bottom surface of the wafer can also be subjected to water-repellent treatment by spraying the water-repellent agent solution or the like from the back surface side. By making the bottom surface water-repellent, influence by foreign matters on an exposure apparatus stage due to reaching of the liquid for liquid immersion to the bottom surface during liquid immersion exposure or the like can be eliminated. A back rinse nozzle for removing a coating film according to an existing technique may be used as it is as that nozzle for making the back surface water-repellent, or if a nozzle other than a nozzle for back rinse is to be used separately, an additional back rinse nozzle is simply provided. An area that should be subjected to water-repellent treatment is the outermost surface of a portion producing force to lift water through capillarity and a portion at the wafer edge where the surface does not extend horizontally. It is a beveled portion of a wafer base itself at a short distance from an outer frame of the stage that most affects capillarity, however, a non-horizontal portion of the coating film inside that portion should desirably be made water-repellent. Therefore, it is not necessary to make the wafer center portion water-repellent, but a prescribed region in the wafer outer peripheral portion should only be made water-repellent.

As water-repellent treatment is performed using the edge rinse mechanism of a coating apparatus, a minimum value of a region to be made water-repellent is determined depending on positioning accuracy of edge rinse (approximately 0.2mm to 0.3mm). In addition, a maximum value is determined such that the number of effective chips (marked with a circle) in an edge exposure shot is not decreased as seen in the enlarged view of the wafer edge in Fig. 8B. Normally, depending on various process conditions as described below, an edge rinse removal width of the resist may be as large as approximately 3.0mm, and even in such a case, product yield is not affected despite water-repellent treatment extending as far as 3.0mm. Therefore, such a value as not decreasing the number of effective chips refers to a maximum edge rinse removal width. Here, the surface of the substrate before or after formation of the resist film for photolithographic patterning is subjected to water-repellent treatment. In addition, if the resist film for photolithographic patterning has a multi-layer structure, any surface before and after application and formation of each layer in a multi-layer film stack can be treated. As to selection of a water-repellent agent to be used for water-repellent treatment, a water-repellent agent that reacts with the substrate at room temperature is preferably selected. In a case of a less reactive water-repellent agent, after the water-repellent agent solution is brought in contact with the surface, heat treatment at a temperature from 60°C to 120°C can also be performed for approximately 1 minute by using a hot plate or the like, and preferably, heat treatment at a temperature from 110°C to 150°C is performed. If the temperature for heat treatment is too low, reaction between the water-repellent agent and the substrate may not be assisted. Alternatively, if the temperature for heat treatment is too high, characteristics of a stack film present on the substrate may vary, which is not preferred.

A water-repellent agent of fluorines, a water-repellent agent of silicones, a water-repellent agent of fluorines and silicones, a silane coupling agent, a silylation agent, an alkylating agent, or an acylation agent may be used as the water-repellent agent. A single agent or a mixture of two or more of the above may be employed. In any case, a water-repellent agent is diluted with a solvent suitable for each water-repellent agent to attain a concentration of 0.5 mass % to 5.0 mass % for use. Examples of the water-repellent agents include those shown with Formula (1) and Formula (2) below. In order to avoid hydrolysis of the water-repellent agent, the solvent to be used is dehydrated through distillation, use of an absorbent, or use of a moisture-removing filter, to such an extent that moisture is preferably not higher than 50ppm and more preferably not higher than 30ppm. Here, an amount of moisture can be determined by Karl Fischer method.

Exemplary water-repellent agent of fluorines, water-repellent agent of silicones, and water-repellent agent of fluorines and silicones are as follows. 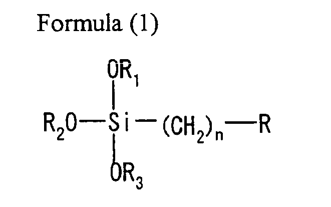 (In Formula (1), R₁, R₂ and R₃ represent H, CH₃, C₂H₅, or C₃H₇, n represents an integer from 0 to 5, R represents CₘF₂ₘ₊₁ or CₘH₂ₘ₊₁, and m represents an integer from 0 to 10.) 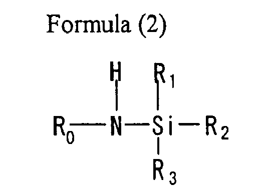 (In Formula (2), R₁, R₂, and R₃ represent (CH₂).-CₘF₂ₘ₊₁, n represents an integer from 0 to 5, m represents an integer from 0 to 10, R₀ represents H, CₖH₂ₖ₊₁, Si(OCH₃)₃, Si(OC₂H₅)₃, Si(OC₃H₇)₃, or the same structure as the structure on the right ofNH bond (SiR₁R₂R₃), and k represents an integer from 1 to 3.)

Where the entire surface of the wafer is subjected to water-repellent treatment, in a case of the water-repellent agent of fluorines, interaction with the wafer may not be sufficient and suppression of pattern toppling may be insufficient. Where the compound shown with Formula (2) above containing alkyl group or epoxy group is used as the water-repellent agent, adhesion can be improved, and improvement in adhesion is greater than conventional treatment using HMDS or the like. Consequently, an effect to suppress pattern toppling is significantly improved. In Formula (2) above, amino group is preferably located at the terminal.

A silylation agent may also be employed as the water-repellent agent. For example, BSA (N,O-bis(trimethylsilyl)acetamide), BSTFA (N,O-bis(trimethylsilyl)trifluoroacetamide), HMDS (hexamethyldisilazane), MSTFA (N-methyl-N-trimethylsilyl-trifluoroacetamide), TMCS (trimethylchlorosilane), TMSI (N-trimethylsilylimidazole), DMSDMA (dimethylsilyldimethylamine), or the like is employed as the silylation agent.

A silane coupling agent may mainly be used as a water-repellent agent having adhesion-strengthening effect. In addition, some silane coupling agents exhibit water-repellent treatment performance. A propoxysilane derivative is effective as the agent having high water-repellent treatment performance, because it is slow in hydrolysis in water. Examples of silane coupling agents include vinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, (aminoethyl)3-aminopropylmethyldimethoxysilane, N-2(aminoethyl)3-aminopropyltrimethoxysilane, N-2(aminoethyl)3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, N-(vinylbenzyl)-2-aminoethyl-3-aminopropyltrimethoxysilane, 3-ureidepropyltriethoxysilane, 3-chloropropyltrimethoxysilane, 3-mercaptopropylmethyldimethoxysilane, 3 -mercaptopropyltrimethoxysilane, bis(triethoxysilylpropyl) tetrasulfide, 3-isocyanatepropyltriethoxysilane, and the like, and among these, a substance in which methoxysilane or ethoxysilane is substituted with propoxysilane is effective as the water-repellent agent. In adhesion-strengthening treatment, a highly reactive methoxysilane derivative is preferred. In order to avoid hydrolysis of the water-repellent agent solution containing the silane coupling agent, a solvent to be used is dehydrated through distillation, use of an absorbent, or use of a moisture-removing filter, to such an extent that moisture is preferably not higher than 50ppm and more preferably not higher than 30ppm.

Pentafluorobenzyi bromide, 1, 4, 7, 10, 13, 16-hexaoxacyclooctadecane, or the like is employed as an alkylating agent. In addition, PFPA (pentafluoropropionic acid anhydride), HFBA (anhydrous heptafluorobutyric acid), acetic anhydride, or the like is employed as an acylation agent. If an organic film such as the lower organic film layer and the photosensitive resist layer included in the multi-layer resist is to be subjected to water-repellent treatment, a water-repellent agent solution obtained by dissolving a compound having a structure as shown in Formula (3) or Formula (4) below in a solvent not dissolving the organic film by a ratio of 0.5 mass % to 5.0 mass % is desirably employed. 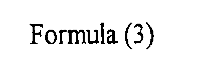 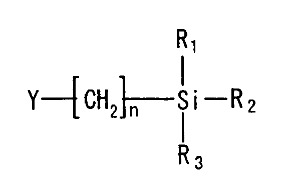 (In Formula (3), R₁, R₂ and R₃ represent methoxy group, ethoxy group, propoxy group, or acetoxy group, n represents an integer from 0 to 5, and functional group Y represents vinyl group, epoxy group, methacryl group, amino group, mercapto group, styryl group, acryloxy group, ureide group, chloropropyl group, sulfide group, isocyanate group, or alkoxy group.) 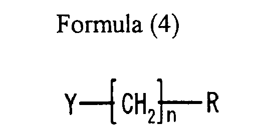 (In Formula (4), R represents CₘF₂ₘ₊₁ or CₘH₂ₘ₊₁, m represents an integer from 0 to 10, n represents an integer from 0 to 5, and functional group Y represents vinyl group, epoxy group, methacryl group, amino group, mercapto group, styryl group, acryloxy group, ureide group, chloropropyl group, sulfide group, isocyanate group, or alkoxy group.)

Based on the above, Table 1 exemplifies preferred combination of water-repellent agents, separately for inorganic films and organic films that are materials to be treated. On the other hand, Table 2 exemplifies preferred solvents, in which the solvents being categorized into a solvent dissolving a multi-layer resist layer, a solvent not dissolving a multi-layer resist layer, and a solvent not dissolving either a top coat layer soluble in a developer. In addition, a solvent dissolving a coating film before curing with heat is preferably selected in treatment of an exposed substrate simultaneous with edge rinse. Moreover, when a coating film is to be treated but edge rinse is not performed, a solvent not dissolving the coating film is preferably selected. On the other hand, heat treatment after coating is performed immediately after the treatment, an ethoxy silanol derivative or a propoxy silanol derivative is preferred as the silane coupling agent, in terms of lower hydrolytic characteristic and improved hydrophobicity. If coating treatment is performed instead of heat treatment immediately after the treatment, a methoxy silanol derivative that reacts at room temperature is preferred. In order to obtain both effects of water repellency and adhesion-strengthening of the water-repellent agent with a single type of solution, a liquid mixture of the water-repellent agent having a structure as shown in Formula (1) and a moderately reactive silane coupling agent of ethoxy silanols is suitably used. Moreover, as the water-repellent agent having a structure shown in Formula (2) and a compound of silazanes used as a silylation agent generate ammonia as a by-product, attention should be paid to patterning. Further, mixing two or more types of water-repellent agents for use as above is preferred, because a highly versatile, water-repellent and adhesion-strengthening material can be obtained by ensuring reactivity with various substrates.

**Table 1**

| Material to be Treated | Water-Repellent Agent | Water-Repellent Agent Having Adhesion-Strengthening Effect |
|---|---|---|
| Inorganic Film | Formula (1) | Silane coupling agent (*2) |
| | Formula (2) | |
| | Silane coupling agent (*1) | |
| | Silylation agent | |
| Organic Film | Formula (3) | Silane coupling agent (*2) |
| | Alkylating agent | |
| | Acylation agent | |

| | | |
|---|---|---|
| (1*) A methoxy silanol derivative is preferred when reaction is to be completed at room temperature. (2*) In order to maintain water-repellent treatment performance, propoxy silanol having low hydrolytic characteristic is preferred. When importance is placed on reactivity at room temperature, methoxy silanol is preferred. | | |

When importance is placed on versatility, ethoxy silanol is preferred.

**Table 2**

| | |
|---|---|
| Solvent Dissolving Multi-Layer Resist Layer (*3) | Solvent of acetates such as PGMEA (propyleneglycohnonomethylether acetate) |
| | Solvent of glycol ethers such as PGME (propyleneglycolmonomethylether) |
| | Solvent of ketones such as cyclohexanone and γ-butyllactone |
| Solvent Not Dissolving Multi-Layer Resist Layer (*3) | Higher alcohol having carbon atoms more than C₄ |
| | Solvent of ethers |
| | Non-polar solvent |
| Solvent Not Dissolving Either Top Coat Layer Soluble in Liquid Immersion Development | Water |

| | |
|---|---|
| (*3) Except for top coat layer soluble in liquid immersion development | |

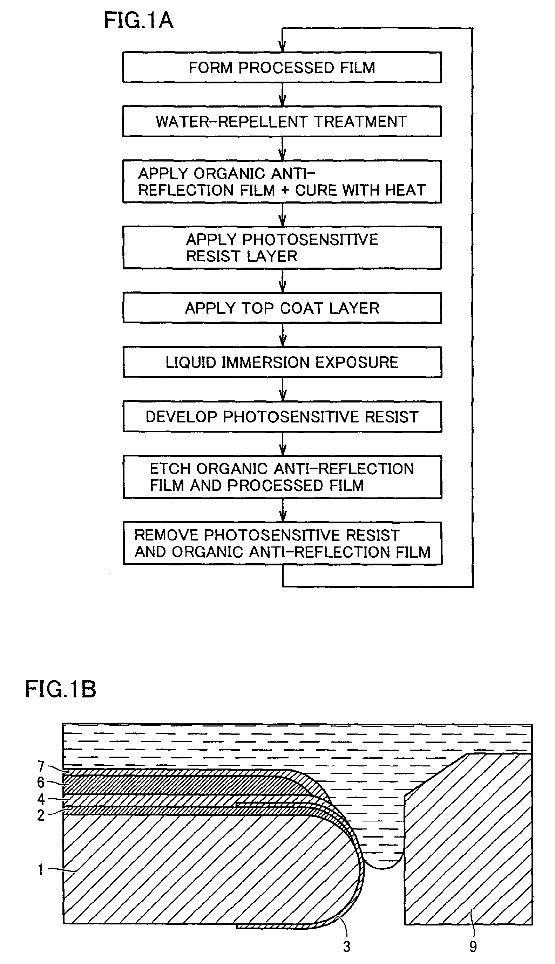

Figs. 1A and 1B and Figs. 9A-9C to Figs. 13A-13C show typical examples of water-repellent treatment according to the present invention. Basically, preferably, treatment with a water-repellent agent solution containing a silane coupling agent and having an effect to strengthen adhesion is performed on films poor in adhesion between the upper layer and the lower layer, while water-repellent treatment with a water-repellent agent solution without containing a silane coupling agent is performed after all layers are formed. On the other hand, peeling in a subsequent process for exposure to light, etching, diffusion, or injection, dust production caused by physical contact in clamping or the like, dust production resulting from peeling due to characteristics of a film itself, or the like may occur. Depending on such various process conditions, necessity of removal of the lower organic film layer, the silicon-containing intermediate layer, the photosensitive resist layer, and the top coat layer soluble in a developer at a resist edge portion is determined, and therefore, various process flows are necessary. Examples below represent exemplary process flows, and many variations are possible depending on conditions.

Figs. 1A and 1B show examples where the top coat layer covers the outermost surface; Fig. 1A shows a process flow and Fig. 1B shows a cross-sectional structure of the wafer outer peripheral portion after treatment. As shown in Fig. 1B, after a processed film 2 is formed on a substrate 1, a water-repellent layer 3 composed of the water-repellent agent solution according to the present invention is formed. Thereafter, a coating-type organic anti-reflection film 4, a photosensitive resist layer 6, and a top coat layer 7 are formed. The surface to be subjected to water-repellent treatment is generally an inorganic film, and the agent expressed in Formula (1), the agent expressed in Formula (2), the silylation agent, or the silane coupling agent is desirably used as the water-repellent treatment agent. Here, any compound is diluted with a solvent to attain a concentration of 0.5 mass % to 5.0 mass % for use, however, the solvent to be used may be solvents of alcohols, acetates, ketones, water, or aromatics without particularly restricted, and the solvent high in stability in dissolving the compound may be used. Where the organic film is the surface to be subjected to water-repellent treatment, the agent expressed in Formula (3) or the silane coupling agent containing propoxy silanol or ethoxy silanol is desirably used. As the water-repellent agent solution is supplied onto the substrate, the water-repellent agent is adsorbed on the surface of the substrate and a monomolecular layer of the water-repellent agent is formed as a result of chemical reaction. Therefore, spill of the liquid for liquid immersion from between the substrate and a stage outer peripheral portion 9 can be avoided. After liquid immersion exposure is completed, the photosensitive resist development step and the etching step are performed. Thereafter, in order to remove the resist, ashing using oxygen plasma and wet treatment using a liquid mixture of sulfuric acid and hydrogen peroxide solution are performed. In the wet treatment, water-repellent layer 3 formed on the surface and the back surface is peeled off.

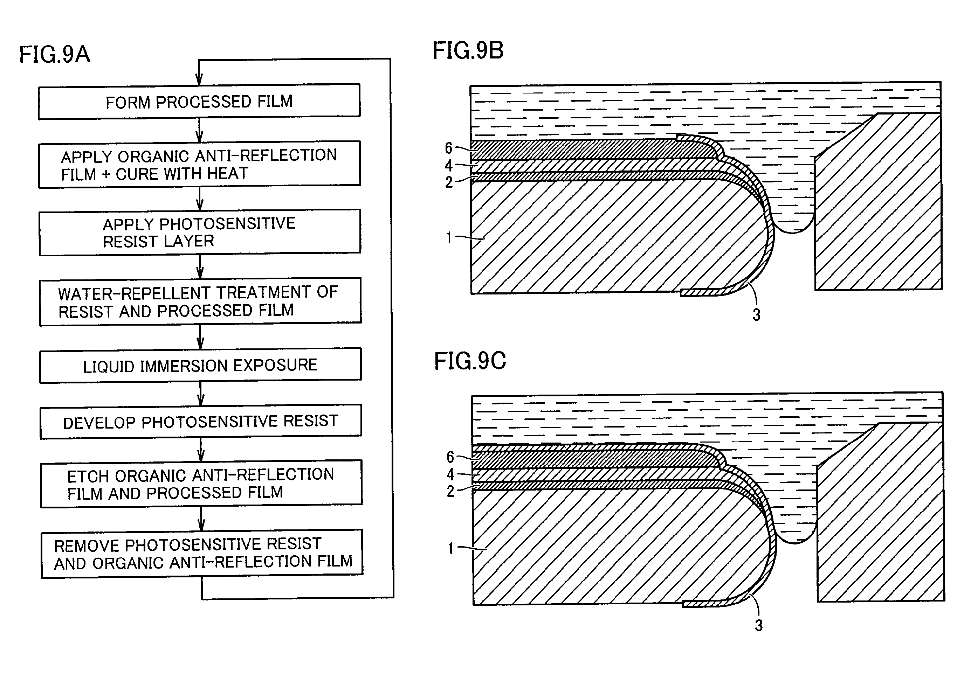

Figs. 9A to 9C show examples where the top coat layer is not formed; Fig. 9A shows a process flow and Figs. 9B and 9C show cross-sectional structures of the wafer outer peripheral portions after treatment. Initially, processed film 2, coating-type organic anti-reflection film 4 and photosensitive resist layer 6 are formed on substrate 1, and thereafter, water-repellent layer 3 is formed. As both of the inorganic film and the organic film are present at the surface to be subjected to water-repellent treatment, a solution mixture of Formulae (1), (2) and (3) or the silane coupling agent containing propoxy silanol or ethoxy silanol is desirably used as the water-repellent agent. In addition, any compound is diluted with a solvent to attain a concentration of 0. mass % to 5.0 mass % for use, however, a solvent not dissolving the photosensitive resist is selected as the solvent to be used, from among higher alcohol having carbon atoms more than butyl alcohol, higher alkyl ether having carbon atoms more than butyl ether, water, and the like. Water-repellent layer 3 is peeled off in a resist removal step. In the example shown in Fig. 9B, water-repellent layer 3 is formed on the side surface of the substrate, the peripheral portion of the top surface of the substrate, and the peripheral portion of the bottom surface of the substrate. On the other hand, in the example shown in Fig. 9C, water-repellent layer 3 is formed on the side surface of the substrate, the top surface of the substrate, and the peripheral portion of the bottom surface of the substrate.

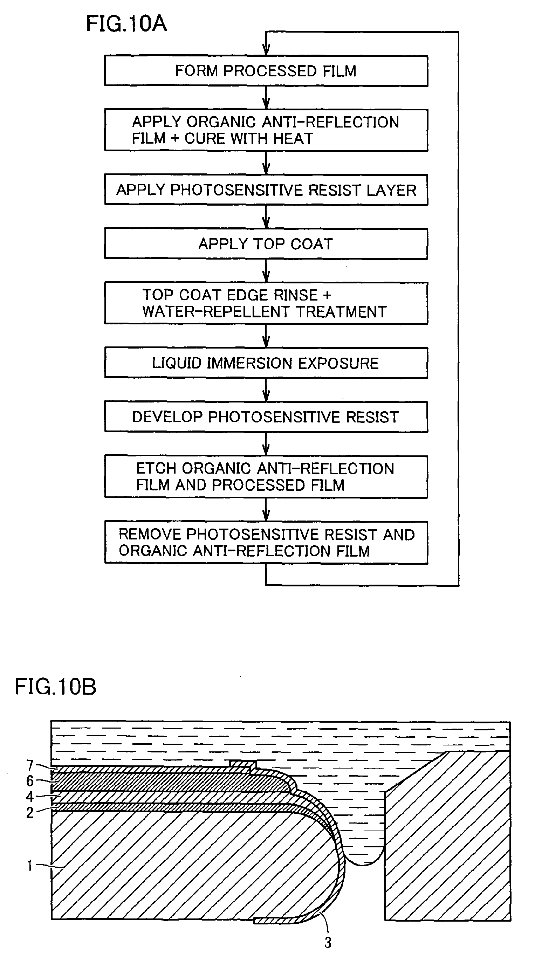

Figs. 10A and 10B illustrate examples where the top coat layer is formed and edge rinse and water-repellent treatment are simultaneously performed; Fig. 10A shows a process flow and Fig. 10B shows a cross-sectional structure of the wafer outer peripheral portion after treatment. As shown in Fig. 10B, processed film 2, coating-type organic anti-reflection film 4, photosensitive resist layer 6, and top coat layer 7 are formed on substrate 1. Thereafter top coat edge rinse is performed and water-repellent layer 3 is formed. As both of the inorganic film and the organic film are present at the surface to be subjected to water-repellent treatment, a solution mixture of Formulae (1), (2) and (3) or the silane coupling agent containing propoxy silanol or ethoxy silanol is desirably used as the water-repellent agent. In addition, any compound is diluted with a solvent to attain a concentration of 0.5 mass % to 5.0 mass % for use. A solvent dissolving the top coat layer soluble in a developer but not dissolving the photosensitive resist is selected as the solvent to be used, from among higher alcohol having carbon atoms more than butyl alcohol, higher alkyl ether having carbon atoms more than butyl ether, and the like, that are used as a solvent for the top coat layer soluble in a developer. Water-repellent layer 3 is peeled off in the resist removal step.

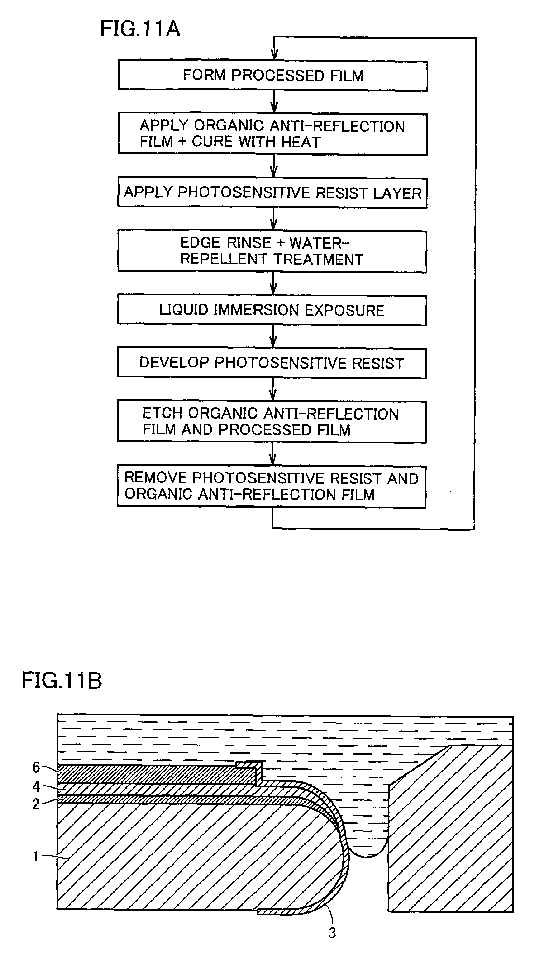

Figs. 11A and 11B illustrate examples where the top coat layer is not formed and edge rinse and water-repellent treatment are simultaneously performed; Fig. 11A shows a process flow and Fig. 11B shows a cross-sectional structure of the wafer outer peripheral portion after treatment. As shown in Fig. 11B, processed film 2, coating-type organic anti-reflection film 4, and photosensitive resist layer 6 are formed on substrate 1, and thereafter, edge rinse is performed and water-repellent layer 3 is formed. As both of the inorganic film and the organic film are present at the surface to be subjected to water-repellent treatment, a solution mixture of Formulae (1), (2) and (3) or the silane coupling agent containing propoxy silanol or ethoxy silanol is desirably used as the water-repellent agent. In addition, any compound is diluted with a solvent to attain a concentration of 0.5 mass % to 5.0 mass % for use. Here, examples of the solvent to be used include a solvent of acetates such as PGMEA (propyleneglycolmonomethylether acetate), a solvent of glycol ethers such as PGME (propyleneglycolmonomethylether), a solvent of ketones such as cyclohexanone and γ-butyllactone, and the like, and a solvent dissolving the photosensitive resist is selected. Water-repellent layer 3 is peeled off in the resist removal step.

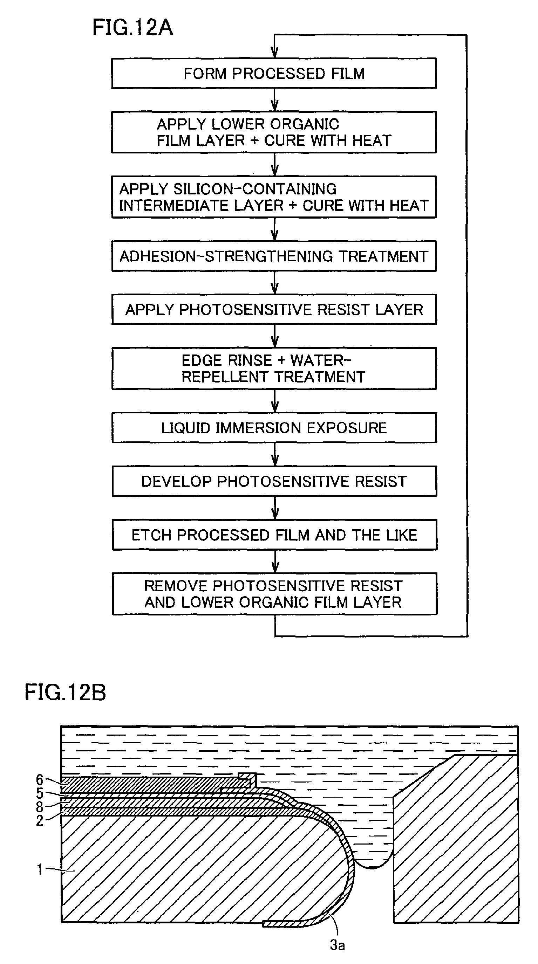

A method of improving adhesion between layered films in order to suppress a pattern defect induced by peeling during liquid immersion exposure of stacked films in the multi-layer resist method will now be described. Figs. 12A and 12B illustrate examples where the top coat layer is not formed, edge rinse of the photosensitive resist layer is performed, and adhesion between the silicon-containing intermediate layer and the photosensitive resist layer is enhanced. Fig. 12A shows a process flow and Fig. 12B shows a cross-sectional structure of the wafer outer peripheral portion after treatment. As shown in Fig. 12B, processed film 2, lower organic film layer 8, and silicon-containing intermediate layer 5 are formed on substrate 1, and thereafter, the surface of silicon-containing intermediate layer 5 is subjected to adhesion-strengthening treatment. Thereafter, immediately after formation of photosensitive resist layer 6, photosensitive resist layer 6 and films under the same are made water-repellent through edge rinse, and a water-repellent and adhesion-strengthening layer 3 a is formed by using a treatment solution containing a silane coupling agent in a water-repellent agent solution. As adhesion-strengthening treatment of silicon-containing intermediate layer 5 is performed immediately before spin-coating with the photosensitive resist, heat treatment is not performed immediately after the treatment and the water-repellent agent that has not reacted is washed away with the solvent dissolving the photosensitive resist. Therefore, a methoxy silanol derivative highly reactive at room temperature is preferably used.

The water-repellent treatment is continuously performed without unloading from a coating cup and heat treatment. The silicon-containing intermediate layer has been cured under heat by this time point and it is not dissolved in the solvent. In next water-repellent treatment, the photosensitive resist layer is subjected to edge rinse, and at the same time, the entire exposed surface of the photosensitive resist and the films under the same should be made water-repellent. As both of the inorganic film and the organic film are present at the surface to be subjected to water-repellent treatment, a solution mixture of Formulae (1), (2) and (3) or the silane coupling agent containing propoxy silanol or ethoxy silanol is desirably used as the water-repellent agent. In addition, any compound is diluted with a solvent to attain a concentration of 0.5 mass % to 5.0 mass % for use, however, a solvent having excellent edge rinse characteristic should be used from among solvents of alcohols, solvents of acetates, solvents of ketones, and the like. The water-repellent agent is adsorbed on the surface subjected to water-repellent treatment, and a monomolecular layer of the water-repellent agent is formed as a result of chemical reaction. Thus, spill of the liquid for liquid immersion can be avoided. After liquid immersion exposure is completed and the photosensitive resist development step and the etching step are performed, ashing using oxygen plasma and wet treatment using a liquid mixture of sulfuric acid and hydrogen peroxide solution are performed in order to remove the resist. Here, the water-repellent layer (water-repellent and adhesion-strengthening layer 3a) is peeled off.

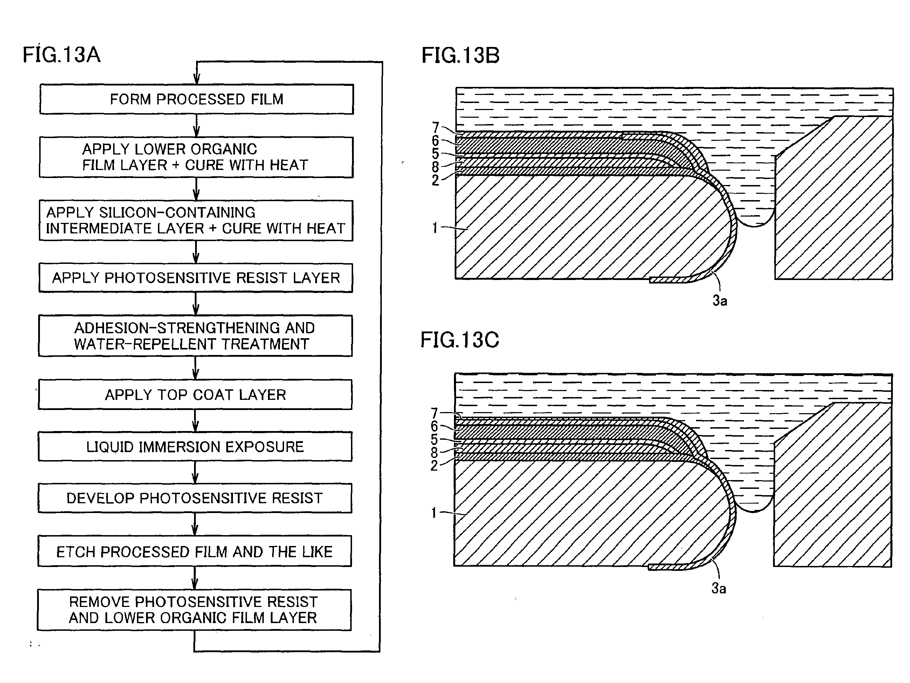

Figs. 13A to 13C illustrate examples where adhesion between the photosensitive resist and the top coat layer is enhanced; Fig. 13A shows a process flow and Figs. 13B and 13C are cross-sectional views of the wafer outer peripheral portion after treatment. Initially, processed film 2, lower organic film layer 8 and silicon-containing intermediate layer 5 are formed on substrate 1 and the resist is applied. Thereafter, baking at approximately 100°C is performed for 1 minute, to form photosensitive resist layer 6. Thereafter, the surface of photosensitive resist layer 6 is treated with the water-repellent agent solution containing the silane coupling agent, and the treated surface of the photosensitive resist layer and the layers under the same where both of the inorganic film and the organic film are present is made water-repellent. Thereafter, top coat layer 7 is formed. By performing treatment with the water-repellent agent solution containing the silane coupling agent before formation of top coat layer 7, adhesion at the interface between photosensitive resist layer 6 and top coat layer 7 soluble in a developer for liquid immersion can be improved. A solvent not dissolving the photosensitive resist layer is selected as the solvent to be used for adhesion-strengthening treatment and water-repellent treatment, from among higher alcohol having carbon atoms more than butyl alcohol, higher alkyl ether having carbon atoms more than butyl ether, water, and the like. Though the adhesion-strengthening treatment and the water-repellent treatment can be performed by using different solvents, treatment with a single liquid is also possible by selecting a treatment agent. Considering the fact that heat treatment is not performed immediately after the treatment and hydrolytic characteristic of alkoxy silanol is suppressed as much as possible, a silane coupling agent containing moderately reactive ethoxy silanol is preferably used for the water-repellent agent solution containing the silane coupling agent. A solution mixture of Formulae (1), (2) and (3) or the silane coupling agent containing propoxy silanol or ethoxy silanol is desirably used as the water-repellent agent. The water-repellent layer is peeled off in the resist removal step.

Fig. 13B illustrates an example where the side surface of the substrate is treated and the peripheral portion of the top surface of the substrate and the peripheral portion of the bottom surface of the substrate are treated, by using a water-repellent agent solution or the like. The side surface of the substrate, the peripheral portion of the top surface of the substrate, and the peripheral portion of the bottom surface of the substrate are regions unlikely to affect a pattern formation region, where adhesion is unstable, peeling is likely during liquid immersion exposure and leakage of the liquid for liquid immersion is likely. Therefore, the outer peripheral portion of such a substrate is preferably made water-repellent and adhesion in that portion is preferably strengthened. In addition, it is also effective that the peripheral portion of the top surface of the substrate or the peripheral portion of the bottom surface of the substrate in addition to the side surface of the substrate is made water-repellent and adhesion around the same is strengthened, depending on variation in a wafer process. Similarly, as shown in Fig. 13C, it is also effective that the side surface of the substrate, the top surface of the substrate and the peripheral portion of the bottom surface of the substrate are made water-repellent and adhesion around the same is strengthened as a result of treatment with the water-repellent agent solution or the like. Moreover, a method of forming a coating film on the substrate, removing the coating film with the solvent dissolving the coating film from the surface of the substrate, the peripheral portion of the top surface of the substrate and the peripheral portion of the bottom surface of the substrate, and treating such a region, from which the coating film has been removed by dissolving the same, with the water-repellent agent solution or the like is preferred, in terms of its improved effect of prevention of dust production and water-repellency by selectively making the outer peripheral portion, of which water-repellency and adhesion are most required, water-repellent and increasing a degree of adhesion in that portion, without affecting patterning.

In addition, in any example described above, other additives or the like may be added to the water-repellent agent solution or the like so long as the effect of the present invention is not impaired. In order to control water-repellent performance and adhesive performance of the water-repellent agent, at least one of water, acid and alkali is preferably contained in each solution to be used. The acid is not particularly limited, however, examples of acids are alkyl carboxylic acid such as acetic acid, and aromatic carboxylic acid. Moreover, though alkali is not particularly limited, organic amine such as tetramethylammonium hydroxide (TMAH) or the like can be employed. Acid and alkali are preferably moderately volatile in terms of chemical stability of a prepared agent, and for example, acid and alkali having a boiling point not lower than 100°C are preferably employed. In the event that a chemical structure changes due to progress of hydrolytic reaction and corresponding oligomerization of the water-repellent agent and consequently desired water-repellency and adhesion are not obtained, the water-repellent agent is dissolved in an undiluted solution (raw material) of such acid or alkali or in an ether solvent in which water such as purified water is controlled preferably to 50ppm or lower, and a resultant solution is stored. Immediately before use, the stored solution and the solvent of alcohols containing desired water above or the solvent dissolving the resist such as PGMEA are mixed for preparation and use. Though the content of water or the like to be added may be determined in consideration of a type, a concentration or the like of the water-repellent agent or the adhesion-strengthening agent, the content thereof is preferably in a range from 0.01 to 5 mass % with respect to the total treatment solution. If desired water-repellency and adhesion should be maintained during long storage of 1 to 2 months or longer, the content of at least one of water, alkali and acid in the treatment solution above should be controlled more precisely. The content in this case is preferably in a range from 0.04 to 2.7 mass % with respect to the total solution, and in order to suppress fluctuation of each value within a range of ±0.2 mass % during storage, preferably, contact with outside air is cut off and purge with nitrogen in a vessel is performed. If acid or alkali is to be added, an amount of addition thereof is adjusted to attain preferably pH 4 to 10 and further preferably pH 6 to 8.

Where at least one of water, alkali and acid is contained in the water-repellent agent solution, if the content of water or the like is too small, required water-repellent performance may not be obtained in any of an example where such a component is mixed immediately before use and an example where such a component is used after mixing and storage. Alternatively, if the content is too large, hydrolysis excessively proceeds, the solution becomes clouded, and desired water-repellency or adhesive performance may not be obtained. Therefore, if quality should be maintained in particular during long storage, the content of water or the like as above and fluctuation are preferably controlled.

For the water-repellent agent solution not dissolving the resist, a solvent of ethers such as diisoamyl ether or n-butyl ether, a solvent of alcohols such as isoamyl alcohol or isopropanol, or a solution mixture thereof may be employed. If the solution mixture is employed, a mixing ratio should be adjusted in consideration of compatibility with at least any of water, acid and alkali to be contained. For example, the ratio is desirably set as follows: solvent of ethers : solvent of alcohols = approximately 5:5 to 7:3. If long storage as above is required, the content of water or the like and fluctuation are desirably suppressed in the range shown above. If the water-repellent agent solution dissolving the resist is mixed with a solvent for use, the treatment solution should be adjusted in a range the same as above, with the "solvent of alcohols" being replaced with the "solvent dissolving the photosensitive resist."

If quality of the water-repellent agent solution is not varied despite addition of water or the like, at least any of water, acid and alkali may be contained in advance in the water-repellent agent solution before use, without controlling the content and fluctuation as above. Here, for example, the content is preferably in a range from 0.01 to 5 mass % with respect to the total treatment solution.

### Examples

The present invention will be described hereinafter in further detail with reference to examples, however, the present invention is not limited thereto.

### (Example 1)

In order to mainly achieve improvement in water-repellency of an Si wafer, a water-repellent agent solution A including a solvent not dissolving the resist was prepared. In addition, in order to mainly achieve improvement in water-repellency of the Si wafer, a water-repellent agent solution D including the solvent dissolving the resist was prepared. For water-repellent agent solution A, 3,3,3-trifluoropropyltrimethoxysilane (KBM7103 manufactured by Shin-Etsu Chemical Co., Ltd.), tridecafluorohexyltrimethoxysilane (SIT8176-0 manufactured by GELEST Inc.), 2-(3,4-epoxycyclohexyl)ethyltrimethoxysilane (KBM303 manufactured by Shin-Etsu Chemical Co., Ltd.), a mixture of KBM7103 and KBM303 (mixing ratio 3:1), or a mixture of SIT8176-0 and TnBM303 (mixing ratio 3:1) was prepared. Each water-repellent agent was dissolved in diisoamyl ether or n-butyl ether, to prepare a dilute solution at a concentration of approximately 3.0 mass %. On the other hand, for water-repellent agent solution D, KBM7103, KBM303, a mixture of KBM7103 and KBM303 (mixing ratio 3:1), or a mixture of SIT8176-0 and KBM303 (mixing ratio 3:1) was prepared. Each water-repellent agent was dissolved in propyleneglycolmonomethylether acetate (PGMEA), to prepare a dilute solution at a concentration of approximately 3.0 mass %. In order to avoid hydrolysis of the water-repellent agent, the solvent to be used was dehydrated through distillation, use of an absorbent, or use of a moisture-removing filter, to such an extent that moisture was not higher than 50ppm.

In the present example, water-repellent agent solution A alone was used as the water-repellent agent solution, and water-repellent agent solution D alone was used as the water-repellent agent solution. In addition, in accordance with the process flow in Fig. 1A, the wafer having the structure shown in Fig. 1B was manufactured. Initially, after processed film 2 was formed on the irradiated surface of Si substrate 1, the coating cup shown in Fig. 5 was used to inject the water-repellent agent solution, and water-repellent layer 3 was formed. In forming water-repellent layer 3, while the wafer was turned at 1000rpm, the nozzle was stopped at a position 0.5mm away from the wafer edge and the solution was injected from the edge rinse nozzle in the direction of the top surface of the wafer and from the back rinse nozzle in the direction of the bottom surface, so that water-repellent and adhesion-strengthening reaction was allowed to proceed. By optimizing a time period of injection of the water-repellent agent solution from the nozzle and the number of revolutions of the wafer, an amount of adsorption of the water-repellent agent could be controlled and water-repellency could be adjusted.

Thereafter, coating-type organic anti-reflection film 4 was formed to a film thickness from approximately 40nm to 80nm, and heating and curing at 200°C to 250°C was performed for approximately 1 to 1.5 minute. Thereafter, spin-coating with an ArF chemically-amplified positive resist of methacrylates (film thickness from 100nm to 200nm) was performed and bake treatment at 120°C was performed for 60 seconds, to form photosensitive resist layer 6. In succession, top coat layer 7 soluble in a developer was applied to the resist to a film thickness from approximately 3 5nm to 90nm and bake treatment at 110°C was performed for 60 seconds, to form the resist film. As described above, only the wafer peripheral portion except for the wafer center portion that affects patterning could be subjected to the water-repellent and adhesion-strengthening treatment.

The substrate coated with the resist was subjected to light exposure treatment in the liquid immersion exposure apparatus, and thereafter, development treatment with 2.38 mass % solution of tetramethylammonium hydroxide was performed, to complete pattern formation. Using the resist film as a mask, the processed film was subjected to plasma dry etching. As to plasma dry etching of the processed film, polysilicon in the step of forming a transistor was subjected to plasma dry etching. After etching was completed, the photosensitive resist layer and the coating-type organic anti-reflection film were removed through O₂ plasma ashing and wet treatment using sulfuric acid and hydrogen peroxide solution. Here, it was also confirmed that the previously formed water-repellent layer was peeled off. Thereafter, a silicon oxide film in a contact hole forming step (contact step) was formed, and the present example was repeated with the surface thereof serving as the irradiated surface. Thus, pattern formation in the contact step was completed. Similarly, an interconnection forming step (metal step) and a via step were repeatedly performed to complete a semiconductor device. No spill of the liquid for liquid immersion was observed during liquid immersion exposure in any of the example where water-repellent agent solution A alone was used as the water-repellent agent solution, the example where water-repellent agent solution D alone was used as the water-repellent agent solution, and the example where water-repellent agent solutions A and D were mixed for use as the water-repellent agent solution.

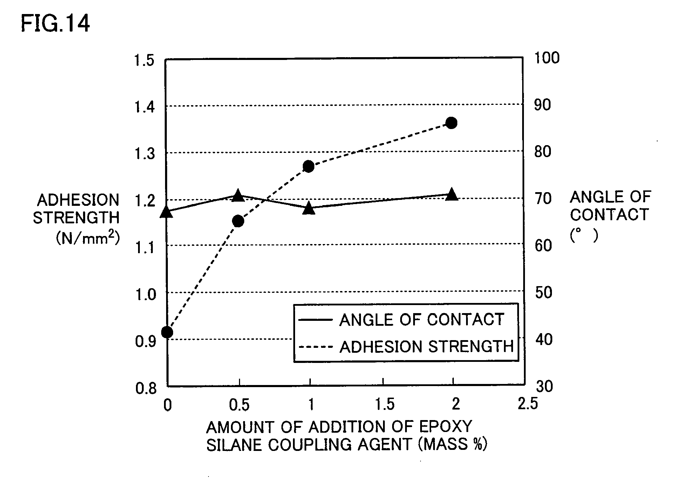

Table 3 and Fig. 14 show adhesion strength and angle of contact when concentration of 2-(3,4-epoxycyclohexyl)ethyltrimethoxysilane (KBM303) representing the epoxy silane coupling agent was varied between 0 mass % and 2.0 mass % while concentration of tridecafluorohexyltrimethoxysilane (SIT8176-0) with respect to diisoamyl ether was fixed to 3.0 mass %. As can clearly be seen from the result in Fig. 14, by increasing an amount of epoxy silane coupling agent, adhesion strength could be raised to 1.35N/mm² or higher while maintaining the angle of contact as high as approximately 70°.

**Table 3**

| Epoxy Silane Coupling Agent (mass %) | Adhesion Strength (N/mm²) | Angle of Contact (°) |
|---|---|---|
| 0.0 | 0.93 | 67.3 |
| 0.5 | 1.17 | 70.9 |
| 1.0 | 1.29 | 68.0 |
| 2.0 | 1.38 | 70.8 |

### (Example 2)

In the present example, water-repellent agent solution A or a water-repellent agent solution B was employed as the water-repellent agent solution. Water-repellent agent solution A used in Example 1 was also used here. In order to mainly achieve improvement in water-repellency of the organic film, water-repellent agent solution B was prepared by using the solvent not dissolving the resist. As the water-repellent agent, decyltrimethoxysilane (KBM3103C manufactured by Shin-Etsu Chemical Co., Ltd.), KBM7103, or a mixture of KBM3103C and KBM7103 (mixing ratio 1:1) was used. KBM 303 mixed at a mixing ratio of 3:1 with respect to the total mass of the water-repellent agent above was used as the water-repellent agent having adhesion-strengthening effect. Each water-repellent agent was dissolved in diisoamyl ether or n-butyl ether, to prepare a dilute solution at a concentration of 3.0 mass %. In order to avoid hydrolysis of the water-repellent agent, the solvent to be used was dehydrated through distillation, use of an absorbent, or use of a moisture-removing filter, to such an extent that moisture was not higher than 50ppm.

In the present example, in accordance with the process flow in Fig. 9A, the wafer having the structure shown in Figs. 9B and 9C was manufactured. Initially, after processed film 2 was formed on the irradiated surface of Si substrate 1, coating-type organic anti-reflection film 4 was formed to a thickness from approximately 40nm to 80nm. The solvent was sufficiently volatilized through heating and curing treatment at 200°C to 250°C for approximately 1 to 1.5 minute, and polymers were cross-linked as a result of reaction at a site that is activated by heat reaction (hereinafter referred to as a heat reaction active site). Thereafter, spin-coating with an ArF chemically-amplified positive resist of methacrylates (film thickness from 100nm to 200nm) was performed and bake treatment at 120°C was performed for 60 seconds, to form photosensitive resist layer 6. Thereafter, using the coating cup shown in Fig. 4 or 5, in the case of Fig. 4, the water-repellent agent solution was applied with a straight nozzle while the wafer was turned at 1000rpm, so that water=repellent layer 3 was formed at the top surface of the wafer, the side surface of the wafer, and the peripheral portion of the bottom surface of the wafer as shown in Fig. 9C. Alternatively, in the case of Fig. 5, the water-repellent agent solution was applied in such a manner that, while the wafer was turned at 1000rpm, the nozzle was stopped at a position 0.5mm away from the wafer edge and the water-repellent agent solution was injected from the edge rinse nozzle onto the top surface of the wafer and from the back rinse nozzle onto the bottom surface. Consequently, except for the center region of the top surface of the wafer that affects patterning, the peripheral portion of the top surface of the wafer, the side surface of the wafer, and the peripheral portion of the bottom surface of the wafer could be made water-repellent. In addition, by optimizing a time period of injection of the water-repellent agent solution from the nozzle and the number of revolutions of the wafer, an amount of adsorption of the water-repellent agent could be controlled and water-repellency could be adjusted.

After water-repellent layer 3 was formed, light exposure treatment in the liquid immersion exposure apparatus was performed. Here, spill of the liquid for liquid immersion during liquid immersion exposure was not observed. Thereafter, development treatment with 2.38 mass % solution of tetramethylammonium hydroxide was performed, to complete pattern formation. Using the resist film as a mask, the processed film was subjected to plasma dry etching. As to plasma dry etching of the processed film, polysilicon in the step of forming a transistor was subjected to plasma dry etching. In any case, after etching was completed, the resist and the organic anti-reflection film were removed through O₂ plasma ashing and wet treatment using sulfuric acid and hydrogen peroxide solution. Here, it was also confirmed that the previously formed water-repellent layer was peeled off. In succession, a silicon oxide film in the contact step was formed, and the present example was repeated with the surface thereof serving as the irradiated surface. Thus, pattern formation in the contact step was completed. Similarly, the metal step and the via step were repeatedly performed to complete the semiconductor device.

### (Example 3)

In the present example, in accordance with the process flow in Fig. 10A, the wafer having the structure shown in Fig. 10B was manufactured. Here, water-repellent agent solution A alone was used as the water-repellent agent solution, water-repellent agent solution B alone was used as the water-repellent agent solution, and a mixture of water-repellent agent solution A and water-repellent agent solution B (mixing ratio 5:5) was used as the water-repellent agent solution. Water-repellent agent solution A used in Example 1 was also used here, and water-repellent agent solution B used in Example 2 was also used here. Initially, after processed film 2 was formed on substrate 1, coating-type organic anti-reflection film 4 was formed to a thickness from approximately 40nm to 80nm. The solvent was sufficiently volatilized through heating and curing treatment at 200°C to 250°C for approximately 1 to 1.5 minute, and polymers were cross-linked as a result of reaction at a heat reaction active site. Thereafter, spin-coating with an ArF chemically-amplified positive resist of methacrylates (film thickness from 100nm to 200nm) was performed and bake treatment at 120°C was performed for 60 seconds, to form photosensitive resist layer 6. Thereafter, immediately after coating with top coat layer 7 soluble in a developer to a film thickness from approximately 35nm to 90nm, using the coating cup shown in Fig. 5, water-repellent layer 3 was formed only at the outer peripheral portion of the wafer. In forming water-repellent layer 3, while the wafer was turned at 1000rpm, the nozzle was stopped at a position 0.5mm away from the wafer edge, the water-repellent agent solution was injected from the edge rinse nozzle onto the top surface of the wafer and from the back rinse nozzle onto the bottom surface, and edge cut of the top coat layer and water-repellent reaction were allowed to proceed simultaneously. Thereafter, bake treatment at 110°C was performed for 60 seconds, to form the resist film.

After the water-repellent layer was formed, the substrate was exposed to light in the liquid immersion exposure apparatus. No spill of the liquid for liquid immersion was observed during liquid immersion exposure. Thereafter, development treatment with 2.3 mass % solution of tetramethylammonium hydroxide was performed, to complete pattern formation. Using the resist film as a mask, the processed film was subjected to plasma dry etching. As to plasma dry etching of the processed film, polysilicon in the step of forming a transistor was subjected to plasma dry etching. In any case, after etching was completed, the resist and the organic anti-reflection film were removed through O₂ plasma ashing and wet treatment using sulfuric acid and hydrogen peroxide solution. Here, it was also confirmed that the previously formed water-repellent layer was peeled off Thereafter, a silicon oxide film in the contact step was formed, and the present example was repeated with the surface thereof serving as the irradiated surface. Thus, pattern formation in the contact step was completed. Similarly, the metal step and the via step were repeatedly performed to complete the semiconductor device.

Here, concentration of 2-(3,4-epoxycyclohexyl)ethyltrimethoxysilane (KBM303) representing the epoxy silane coupling agent was varied between 0 mass % and 2.0 mass % while concentration of tridecafluorohexyltrimethoxysilane (SIT8176-0) was fixed to 3.0 mass %. Consequently, by increasing an amount of epoxy silane coupling agent, adhesion strength could be raised while maintaining an angle of contact at high level.

### (Example 4)

In the present example, water-repellent agent solution D or a water-repellent agent solution E was employed as the water-repellent agent solution. Water-repellent agent solution D used in Example 1 was also used here. In order to mainly achieve improvement in water-repellency of the organic film, water-repellent agent solution E was prepared by using the solvent dissolving the resist. As the water-repellent agent, decyltrimethoxysilane (KBM3103C manufactured by Shin-Etsu Chemical Co., Ltd.), KBM7103, or the mixture of KBM3103C and KBM7103 (mixing ratio 1:1) was used. As the water-repellent agent having adhesion-strengthening effect, KBM 303 mixed at a mixing ratio of 3:1 with respect to the total mass of the water-repellent agent above was prepared. Each water-repellent agent was dissolved in PGMEA, to prepare a dilute solution at a concentration of 3.0 mass %. In order to avoid hydrolysis of the water-repellent agent, the solvent to be used was dehydrated through distillation, use of an absorbent, or use of a moisture-removing filter, to such an extent that moisture was not higher than 50ppm.

In the present example, in accordance with the process flow in Fig. 11A, the wafer having the structure shown in Fig. 11B was manufactured. Initially, after processed film 2 was formed on substrate 1, coating-type organic anti-reflection film 4 was formed to a thickness from 40nm to 80nm. The solvent was sufficiently volatilized through heating and curing treatment at 200°C to 250°C for approximately 1 to 1.5 minute, and polymers were cross-linked as a result of reaction at a heat reaction active site. Thereafter, spin-coating with an ArF chemically-amplified positive resist of methacrylates (film thickness from 100nm to 200nm) was performed, to form photosensitive resist layer 6. In forming the water-repellent layer, using the coating cup shown in Fig. 5, the water-repellent agent solution was applied in such a manner that, while the wafer was turned at 1000rpm, the nozzle was stopped at a position 0.5mm away from the wafer edge, and the water-repellent agent solution was injected from the edge rinse nozzle onto the top surface of the wafer and from the back rinse nozzle onto the bottom surface. In addition, edge cut and water-repellent reaction were allowed to proceed simultaneously. Thereafter, bake treatment at 120°C was performed for 60 seconds, to form the resist film.

Thereafter, light exposure treatment was performed in the liquid immersion exposure apparatus, and spill of the liquid for liquid immersion was not particularly observed. Thereafter, development treatment with 2.38 mass % solution of tetramethylammonium hydroxide was performed, to complete pattern formation. Thereafter, using the resist film as a mask, the processed film was subjected to plasma dry etching. As to plasma dry etching of the processed film, polysilicon in the step of forming a transistor was subjected to plasma dry etching. In any case, after etching was completed, the resist and the organic anti-reflection film were removed through O₂ plasma ashing and wet treatment using sulfuric acid and hydrogen peroxide solution. Here, it was also confirmed that the previously formed water-repellent layer was peeled off. Thereafter, a silicon oxide film in the contact step was formed, and the present example was repeated with the surface thereof serving as the irradiated surface. Thus, pattern formation in the contact step was completed. Similarly, the metal step and the via step were repeatedly performed to complete the semiconductor device.

Here, concentration of 2-(3,4-epoxycyclohexyl)ethyltrimethoxysilane (KBM303) representing the epoxy silane coupling agent was varied between 0 mass % and 2.0 mass % while concentration of tridecafluorohexyltrimethoxysilane (SIT8176-0) was fixed to 3.0 mass %. Consequently, by increasing an amount of epoxy silane coupling agent, adhesion strength could be raised while maintaining an angle of contact at high level.

### (Example 5)

In the present example, in accordance with the process flow in Fig. 12A, the wafer having the structure shown in Fig. 12B was manufactured. Here, water-repellent agent solution D alone was used as the water-repellent agent solution, water-repellent agent solution E alone was used as the water-repellent agent solution, and a mixture of water-repellent agent solution D and water-repellent agent solution E (mixing ratio 5:5) was used as the water-repellent agent solution. Water-repellent agent solution D used in Example 1 was also used here, and water-repellent agent solution E used in Example 4 was also used here. On the other hand, in the present example, a water-repellent agent solution C or a water-repellent agent solution F was used. In order to improve adhesion between the inorganic film and the organic film, water-repellent agent solution C was prepared using the solvent not dissolving the resist. Specifically, a dilute solution at a concentration of 3.0 mass %, that is obtained by dissolving 3-glycidoxypropylmethyltrimethoxysilane (KBE403 manufactured by Shin-Etsu Chemical Co., Ltd.) in diisoamyl ether or n-butyl ether, was used as water-repellent agent solution C. In addition, in order to mainly improve adhesion between the inorganic film and the organic film, water-repellent agent solution F was prepared using the solvent dissolving the resist. Specifically, a dilute solution at a concentration of 3.0 mass %, that is obtained by dissolving 3-glycidoxypropylmethyltrimethoxysilane (KBE403 manufactured by Shin-Etsu Chemical Co., Ltd.) in PGMEA, was used as water-repellent agent solution F. In order to avoid hydrolysis of the water-repellent agent solution containing the silane coupling agent, the solvent to be used was dehydrated through distillation, use of an absorbent, or use of a moisture-removing filter, to such an extent that moisture was not higher than 50ppm.

Initially, after processed film 2 was formed on substrate 1, lower organic film layer 8 was applied to a film thickness from approximately 150nm to 300nm. Then, the solvent was sufficiently volatilized through heating and curing treatment at 200°C to 250°C for approximately 1 to 1.5 minute, and polymers were cross-linked as a result of reaction at a heat reaction active site. Thereafter, in order to form silicon-containing intermediate layer 5, spin-coating with a polymer derivative of silsesquioxanes such as inorganic SOG or organic SOG to a film thickness of approximately 80nm was performed, and the polymer derivatives were cross-linked through dehydration and condensation reaction or reaction at a heat reaction active site such as epoxy functional group through heat treatment at 200°C to 250°C for approximately 1 to 1.5 minute.

Thereafter, using the coating cup shown in Fig. 5, an adhesion-strengthening layer was formed in such a manner that, while the wafer was turned at 1000rpm, the nozzle was stopped at a position 0.5mm away from the wafer edge, and water-repellent agent solution C or water-repellent agent solution F was injected from the edge rinse nozzle onto the top surface of the wafer and from the back rinse nozzle onto the bottom surface. If it is difficult to complete reaction at room temperature, the wafer is transported from a spinner cup to a hot plate where the wafer was heated to 120°C for 60 seconds. By optimizing a time period of injection of the water-repellent agent solution from the nozzle and the number of revolutions of the wafer, an amount of adsorption of the water-repellent agent solution containing the silane coupling agent could be controlled and adhesion strength could be adjusted.

Then, spin-coating with an ArF chemically-amplified positive resist of methacrylates (film thickness from 100nm to 200nm) was performed, to form photosensitive resist layer 6. Thereafter, the coating cup shown in Fig. 5 was used, and while the wafer was turned at 1000rpm, the nozzle was stopped at a position 0.5mm away from the wafer edge and the water-repellent agent solution was injected from the edge rinse nozzle onto the top surface of the wafer and from the back rinse nozzle onto the bottom surface, so that edge cut of the resist and water-repellent reaction were allowed to proceed. Thereafter, bake treatment at 120°C was performed for 60 seconds, to form water-repellent and adhesion-strengthening layer 3a.

Light exposure treatment of the substrate that had been subjected to water-repellent and adhesion-strengthening treatment was performed in the liquid immersion exposure apparatus. As a result, spill of the liquid for liquid immersion was not observed and peeling from the wafer edge due to convection of the liquid for liquid immersion or the like was not observed in any of the example where water-repellent agent solution C alone was used and the example where water-repellent agent solution F alone was used. Thereafter, development treatment with 2.38 mass % solution of tetramethylammonium hydroxide was performed, to complete pattern formation. Using the resist film as a mask, the processed film was subjected to plasma dry etching. As to plasma dry etching of the processed film, polysilicon in the step of forming a transistor was subjected to plasma dry etching. In any case, after etching was completed, the resist and the lower organic film layer were removed through O₂ plasma ashing and wet treatment using sulfuric acid and hydrogen peroxide solution. Here, it was also confirmed that the previously formed water-repellent and adhesion-strengthening layer was peeled off.

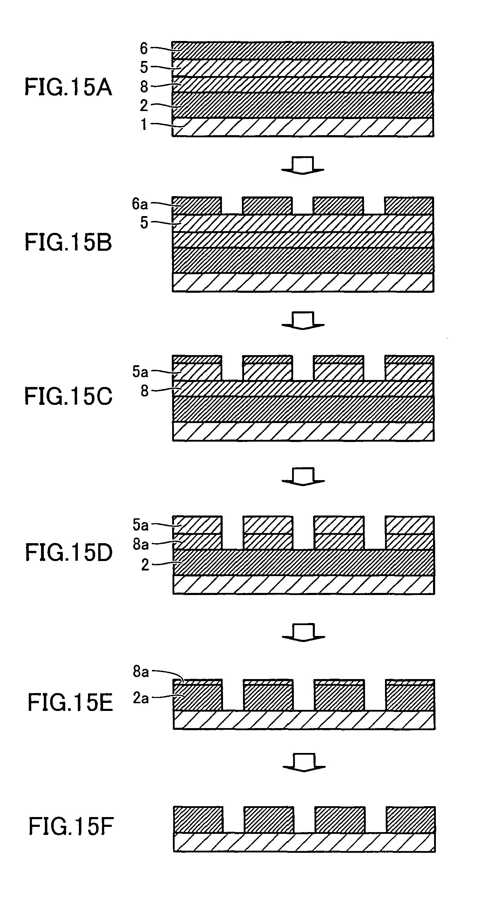

The present example is an example where the top coat layer does not cover the outermost surface of the wafer. Figs. 15A to 15F show the patterning step after the photosensitive resist layer was formed. Initially, the wafer including processed film 2, lower organic film layer 8, silicon-containing intermediate layer 5, and photosensitive resist layer 6 on substrate 1 as shown in Fig. 15A was exposed to light and developed, and a resist pattern 6a was formed as shown in Fig. 15B. Thereafter, as shown in Fig. 15C, using resist pattern 6a as a mask, silicon-containing intermediate layer 5 was etched. Thereafter, as shown in Fig. 15D, using an intermediate layer pattern 5a as a mask, lower organic film layer 8 was etched to form an organic film layer pattern 8a. Successively, as shown in Fig. 15E, using organic film layer pattern 8a as a mask, processed film 2 was etched to form a processed film pattern 2a. Finally, as shown in Fig. 15F, organic film layer pattern 8a was removed to complete pattern formation. Thereafter, the silicon oxide film in the contact step was formed, and the present example was repeated with the surface thereof serving as the irradiated surface. Pattern formation in the contact step was thus completed. Similarly, the metal step and the via step were repeatedly performed to complete the semiconductor device.

### (Example 6)

In the present example, in accordance with the process flow in Fig. 13A, the wafer having the structure shown in Figs. 13B and 13C was manufactured. The following water-repellent agent solutions were used: water-repellent agent solution A; a water-repellent agent solution G which is a mixture of water-repellent agent solution A and water-repellent agent solution C (mixing ratio 5:1); water-repellent agent solution B; a water-repellent agent solution H which is a mixture of water-repellent agent solution B and water-repellent agent solution C (mixing ratio 5:1); a water-repellent agent solution I which is a mixture of water-repellent agent solution A and water-repellent agent solution B (mixing ratio 5:5); and a water-repellent agent solution J which is a mixture of water-repellent agent solution G and water-repellent agent solution H (mixing ratio 5:5). In addition, water-repellent agent solution A used in Example 1, water-repellent agent solution B used in Example 2, and water-repellent agent solution C used in Example 5 were also used here.

Initially, after processed film 2 was formed on substrate 1, lower organic film layer 8 was applied to a film thickness from approximately 150nm to 300nm. Then, the solvent was sufficiently volatilized through heating and curing treatment at 200°C to 250°C for approximately 1 to 1.5 minute, and polymers were cross-linked as a result of reaction at a heat reaction active site. Thereafter, in order to form silicon-containing intermediate layer 5, spin-coating with a polymer derivative of silsesquioxanes such as inorganic SOG or organic SOG to a film thickness of approximately 80nm was performed, and the polymer derivatives were cross-linked through dehydration and condensation reaction or reaction at a heat reaction active site such as epoxy functional group through heat treatment at 200°C to 250°C for approximately 1 to 1.5 minute.

Thereafter, spin-coating with an ArF chemically-amplified positive resist of methacrylates (film thickness from 100nm to 200nm) was performed to form photosensitive resist layer 6, and water-repellent and adhesion-strengthening layer 3 a was formed by using the coating cup shown in Fig. 4 or 5. In the case of Fig. 4, each water-repellent agent solution above was applied with a straight nozzle while the wafer was turned at 1000rpm, so that water-repellent and adhesion-strengthening layer 3 a was formed at the top surface of the wafer, the side surface of the wafer, and the peripheral portion of the bottom surface of the wafer as shown in Fig. 13C. Alternatively, in the case of Fig. 5, while the wafer was turned at 1000rpm, the nozzle was stopped at a position 0.5mm away from the wafer edge, and each water-repellent agent solution was injected from the edge rinse nozzle onto the top surface of the wafer and from the back rinse nozzle onto the bottom surface. Consequently, as shown in Fig. 13B, water-repellent and adhesion-strengthening layer 3a was formed at the peripheral portion of the top surface of the wafer, the side surface of the wafer, and the peripheral portion of the bottom surface of the wafer. Thereafter, bake treatment at 120°C was performed for 60 seconds, top coat film 7 soluble in a developer was applied onto the resist to a film thickness from approximately 35nm to 90nm, and bake treatment at 110°C was performed for 60 seconds.

As a result of light exposure treatment in the liquid immersion exposure apparatus, spill of the liquid for liquid immersion was not observed with regard to any water-repellent agent solution. In addition, peeling from the wafer edge due to convection of the liquid for liquid immersion or the like was not observed. Thereafter, development treatment with 2.3 8 mass % solution of tetramethylammonium hydroxide was performed, to complete pattern formation. Using the resist film as a mask, the processed film was subjected to plasma dry etching. As to plasma dry etching of the processed film, polysilicon in the step of forming a transistor was subjected to plasma dry etching. In any case, after etching was completed, the resist and the lower organic film layer were removed through O₂ plasma ashing and wet treatment using sulfuric acid and hydrogen peroxide solution. Here, it was also confirmed that the previously formed water-repellent and adhesion-strengthening layer was peeled off

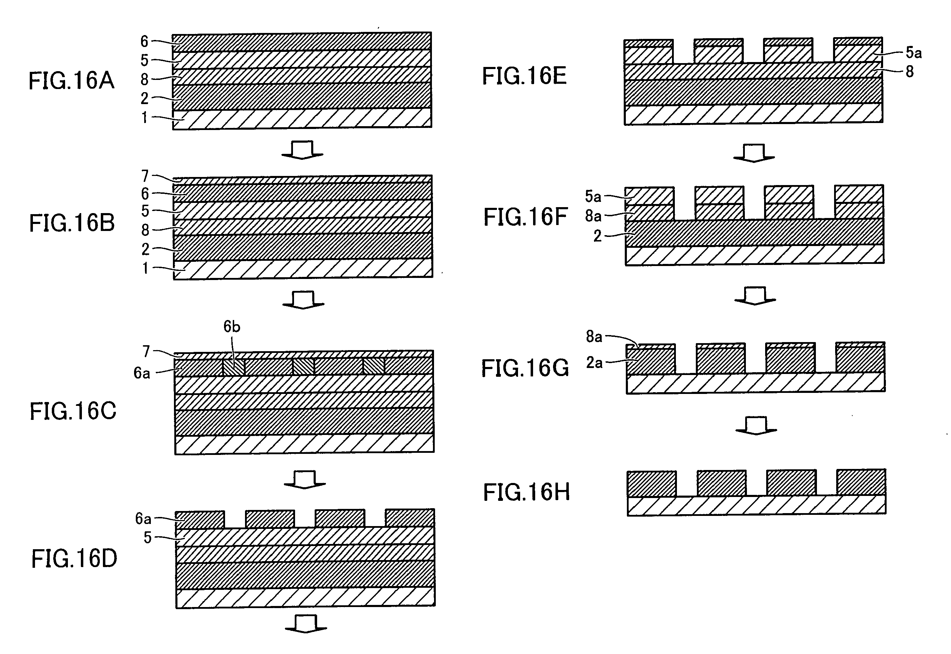

Figs. 16A to 16H illustrate the patterning step after the photosensitive resist layer was formed in the example where the top coat layer soluble in a developer covers the outermost surface of the wafer and the water-repellent and adhesion-strengthening layer was formed only at the outer peripheral portion of the wafer in the present example. Initially, in the wafer including processed film 2, lower organic film layer 8, silicon-containing intermediate layer 5, and photosensitive resist layer 6 on substrate 1 as shown in Fig. 16A, top coat layer 7 soluble in a developer was formed as shown in Fig. 16B. In succession, exposure to light as shown in Fig. 16C and development as shown in Fig. 16D were performed, to remove top coat layer 7 soluble in a developer and a light exposed portion 6b of the resist, and resist pattern 6a was formed. Thereafter, as shown in Fig. 16E, using resist pattern 6a as a mask, silicon-containing intermediate layer 5 was etched. Thereafter, as shown in Fig. 16F, using intermediate layer pattern 5a as a mask, lower organic film layer 8 was etched to form organic film layer pattern 8a. In succession, as shown in Fig. 16G, using organic film layer pattern 8a as a mask, processed film 2 was etched to form processed film pattern 2a. Finally, as shown in Fig. 16H, organic film layer pattern 8a was removed and pattern formation was completed. Thereafter, a silicon oxide film in the contact step was formed and the present example was repeated with the surface thereof serving as the irradiated surface. Thus, pattern formation in the contact step was completed. Similarly, the metal step and the via step were repeatedly performed to complete the semiconductor device.

### (Example 7)

The water-repellent treatment was performed in line with the procedure as in Example 1 except that the water-repellent agent solution was changed and the entire wafer surface was subjected to water-repellent treatment, and subsequently the semiconductor device was manufactured. In the present example, a treatment solution A was prepared by adding 0.005ml of ultrapure water to 3g of solution obtained by dissolving 3 mass % tridecafluorohexyltrimethoxysilane (SIT8176-0 manufactured by GELEST Inc.) serving as the water-repellent agent and 1 mass % 2-(3,4-epoxycyclohexyl)ethyltrimethoxysilane (KBM303 manufactured by Shin-Etsu Chemical Co., Ltd.) serving as the water-repellent agent having an adhesion strengthening effect in isoamylether. Layer separation of isoamylether serving as the solvent depending on the content of the ultrapure water did not occur. In addition, a treatment solution B without ultrapure water being added was prepared as control.

In order to evaluate water-repellency of the substrate surface that was subjected to water-repellent treatment, the contact angle at the substrate surface was measured with a contact angle meter (manufactured by Kyowa Interface Science Co., Ltd.). The contact angle when treatment solution B was employed was 41.4°, and the contact angle when treatment solution A to which ultrapure water was added was 54.1°.

### (Example 8)

The entire wafer surface was subjected to water-repellent treatment in line with the procedure as in Example 7, except for employing a treatment solution C to which 0.001ml of 2.38 % solution of tetramethylammonium hydroxide (TMAH) serving as alkali and 0.04ml of isopropyl alcohol (IPA) for improving solubility of TMAH had been added instead of ultrapure water added to treatment solution A, and subsequently the semiconductor device was manufactured. Here, treatment solution B was used as control.

The contact angle when treatment solution B was employed was 41.4°, and the contact angle when treatment solution C to which IPA was added was 58.1°.

### (Example 9)

Three types of treatment solutions, i.e., a treatment solution D obtained by adding 0.002ml of 2.38% TMAH solution to 3g of solution obtained by dissolving 3 mass % tridecafluorohexyltrimethoxysilane (SIT8176-0 manufactured by GELEST Inc.) serving as the water-repellent agent and 1 mass % 2-(3,4-epoxycyclohexyl)ethyltrimethoxysilane (KBM303 manufactured by Shin-Etsu Chemical Co., Ltd.) serving as the water-repellent agent having an adhesion strengthening effect in isopropyl alcohol (IPA), a treatment solution E obtained by adding 0.01ml of 2.38% TMAH solution to the same, and a treatment solution F obtained by adding 0.13ml of 2.38% TMAH solution to the same, were prepared. The entire wafer surface was subjected to water-repellent treatment in line with the procedure as in Example 7 except that treatment solution A was changed to each of these treatment solutions D to F, and subsequently the semiconductor device was manufactured. The results of measurement of pH of each treatment solution with a pH meter are as follows: pH of treatment solution D was 7 to 8; pH of treatment solution E was 7 to 8; and pH of treatment solution F was 9 to 10.

The contact angles when treatment solutions D to F above were employed were 105.1° (treatment solution D), 103.7° (treatment solution E), and 104.5° (treatment solution F), respectively, and there was no great difference between the solutions. In addition, a state of the wafer surface after water-repellent treatment was observed. As to treatment solution D, unevenness in treatment was not observed. As to treatment solution E, slight unevenness in treatment was observed. As to treatment solution F, unevenness in treatment was observed. Determination of unevenness in treatment was made based on visual observation, and determination as uneven treatment was made when uneven color was observed on the treated wafer.

### (Example 10)

The present example is conducted in order to confirm whether water-repellency improved in the treatment above is maintained when formation of the processed film or heat treatment is performed in the wafer subsequent to water-repellent treatment or adhesion-strengthening treatment.

A treatment solution G was prepared by dissolving 1.94 mass % Rf (fluorine-structure-containing) trimethoxysilane (Rf (fluorine-structure-containing) trimethoxysilane (70409 manufactured by Asahi Glass Co., Ltd.) serving as the water-repellent agent and 0.97 mass % 2-(3,4-epoxycyclohexyl)ethyltrimethoxysilane (KBM303 manufactured by Shin-Etsu Chemical Co., Ltd.) serving as the water-repellent agent having an adhesion-strengthening effect in a solvent mixture obtained by mixing amyl alcohol and isoamylether at a volume ratio of 3:7, and by adding thereto ultrapure water to attain a concentration of 1.9 mass %. The entire wafer surface was subjected to water-repellent treatment in line with the procedure as in Example 7, by dropping 1ml of treatment solution G onto the wafer from the edge rinse nozzle that was set to drop the treatment solution onto the wafer center portion. Three wafers subjected to water-repellent treatment as such were fabricated and subjected to initial bake treatment for 1 minute at different temperatures respectively. Thereafter, the contact angle indicating water-repellency of each wafer surface was measured. The temperatures for the initial bake treatment were 110°C, 130°C, and 150°C, respectively. Thereafter, all wafers were subjected to bake treatment at 205°C for 1 minute, and the contact angle was measured again. When the initial bake temperature was set to 110°C, the contact angle was decreased by 9.5°. When the initial bake temperature was set to 130°C, an amount of decrease was 8.4°. When the initial bake temperature was set to 150°C, an amount of decrease was as small as 2.6°. It was found that the contact angle at the wafer surface after decrease was greater when a higher initial bake temperature was set, as compared with treatment at a lower temperature.

According to the embodiment of the present invention, as the substrate is made highly water-repellent, an effect to suppress spill of the liquid for liquid immersion can be enhanced by strong capillary.

Although the present invention has been described and illustrated in detail, it is clearly understood that the same is by way of illustration and example only and is not to be taken by way of limitation, the scope of the present invention being limited only by the terms of the appended claims.

## Claims

1. A method of forming a resist pattern through liquid immersion exposure in which exposure is performed such that a liquid film is formed between a substrate (1) for a semiconductor device on which a processed film (2) is formed and an objective lens arranged above said substrate (1), comprising the step of:
exposing to light the substrate (1) treated with a water-repellent agent solution composed of at least a water-repellent agent and a solvent.

2. The method of forming a resist pattern according to claim 1, wherein
said water-repellent agent is adsorbed on said substrate (1) by supplying said water-repellent agent solution to said substrate (1).

3. The method of forming a resist pattern according to claim 1 or 2, wherein
said water-repellent agent includes at least one of a water-repellent agent of fluorines, a water-repellent agent of silicones, a water-repellent agent of fluorines and silicones, a silane coupling agent, a silylation agent, an alkylating agent, and an acylation agent.

4. The method of forming a resist pattern according to one of claims 1 to 3, wherein
said processed film (2) includes a lower organic film layer (8), a silicon-containing intermediate layer (5), and a photosensitive resist layer (6) formed on said substrate (1),
said processed film (2) is formed with a multi-layer resist method including the step of spin-coating said substrate (1), and
said method of forming a resist pattern further comprises the step of treatment with said water-repellent agent solution at any timing of at least: in all intervals between said steps of spin-coating; before first spin-coating; and after last spin-coating.

5. The method of forming a resist pattern according to claim 4, wherein
said substrate (1) includes a top coat layer, and
said method of forming a resist pattern further comprises the step of treatment with said water-repellent agent solution before formation of said top coat layer.

6. The method of forming a resist pattern according to claim 4 or 5, wherein said water-repellent agent solution includes a silane coupling agent.

7. The method of forming a resist pattern according to one of claims 4 to 6, wherein
said step of treatment with said water-repellent agent solution is the step of treating a side surface of said substrate (1), and a peripheral portion of a top surface of said substrate (1), a peripheral portion of a bottom surface of said substrate (1), or the peripheral portion of the top surface of the substrate (1) and the peripheral portion of the bottom surface of the substrate (1).

8. The method of forming a resist pattern according to one of claims 4 to 6, wherein
said step of treatment with said water-repellent agent solution is the step of treating a side surface of said substrate (1), a top surface of said substrate (1), and a peripheral portion of a bottom surface of said substrate (1).

9. The method of forming a resist pattern according to one of claims 4 to 8, wherein
two or more types of said water-repellent agents are mixed for use.

10. The method of forming a resist pattern according to one of claim 4 to 9, wherein
said step of treatment with said water-repellent agent solution is performed after the steps of forming a coating film on said substrate (1) and removing said coating film with a solvent dissolving said coating film from a side surface of said substrate (1), a peripheral portion of a top surface of said substrate (1), and a peripheral portion of a bottom surface of said substrate (1).

11. The method of forming a resist pattern according to claim 1, wherein
said substrate (1) includes a photosensitive resist layer (6) on said substrate (1),
said photosensitive resist layer (6) is formed in photolithography step including the step of spin-coating said substrate (1), and
said method of forming a resist pattern further comprises the step of treatment with said water-repellent agent solution at any timing of at least: in all intervals between said steps of spin-coating; before first spin-coating; and after last spin-coating.

12. The method of forming a resist pattern according to one of claims 1 to 11, wherein
said water-repellent agent solution contains at least one of water, acid and alkali.

13. A semiconductor device manufactured with the method of forming a resist pattern according to one of claims 1 to 12.
